(19) Europäisches Patentamt

European Patent Office

Office européen des brevets

(11) **EP 1 659 450 A1**

(12) **EUROPEAN PATENT APPLICATION**

(43) Date of publication:
**24.05.2006 Bulletin 2006/21**

(51) Int Cl.:
*G03F 7/20* (2006.01)  *G03F 7/00* (2006.01)

(21) Application number: **05000788.9**

(22) Date of filing: **17.01.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **22.11.2004 GB 0425627**

(71) Applicant: **Liu, Wai Yip**
**Dundee, DD3 6ND (GB)**

(72) Inventor: **Liu, Wai Yip**
**Dundee, DD3 6ND (GB)**

Remarks:
Amended claims in accordance with Rule 86 (2) EPC.

(54) **Apparatus for the fabrication of microstructures**

(57)    The present invention relates to an apparatus for the microfabrication of one or more microstructures. The apparatus includes a first part, at least one supporting member (8) for supporting any or any combination of a mask, an imprinting stamp (5) and/or a wafer (18) in relation to said first part, and a control means. The supporting member (8) is arranged to be selectively movable relative to said first part by way of one or more piezoelectric members under the control of the control means.

**Figure 1a**

EP 1 659 450 A1

**Description**

The present invention relates to an apparatus and system for the microfabrication of structures and, more particularly, for microfabrication involving surface deformation such as mechanical surface disruption.

Whilst the present invention is primarily intended for effecting the microfabrication method disclosed in copending UK Patent Application No. GB0408169.1, the details of which are encorporated herein by reference, it will be appreciated by those skilled in art that this invention is applicable in other conventional photolithographical processing steps, such as heating of organic or photo-curable materials, mask-alignment and/or photo-polymerization commonly employed in semi-conductor manufacturing process.

The process sequence disclosed in UK Informal Patent Application GB0408169.1 can be summarized with slight modifications in Figure 15, wherein:

Step (a) represents the deposition of a photo-curable material on a wafer and dehydrating the same;
Step (b) represents the annealing or partial annealing of the upper boundaries of the would-be sloped sidewalls;
Step (c) represents a step for providing metal layers to mask off areas where the photo-curable material in the micro structure is not required;
Step (d) represents the forming of polymeric mask regions which define the geometric features onto one or more sloped surfaces;
Step (e) represents the heating of the photo-curable material until the photo-curable material reaches a semi-molten viscoelastic state;
Step (f) represents the mechanically disruption of the areas between or enclosed by the annealed areas by applying pressure to form a structure with sloped regions whilst the photocurable material is cooling; and
Step (g) represents the photopolymerisation of the regions of the photo-curable material required for forming the desired microstructures.

During Step (f) of the aforementioned microfabrication sequence, i.e. the mechanical surface disruption step, the surface of any selected region on a photo-curable material is mechanically deformed while the material is cooling from a semi-solid to solid. According to the UK Informal Patent Application GB048169.1, any or any combination of the surface area of the annealed or partially annealed areas, the temperature of the photo-curable material at which mechanical surface disruption takes place and/or the speed at which the photo-curable material is disrupted can be changed to change the side wall profile of the microstructure formed.

In order to form substantially concave surfaces or sloped regions with concave surfaces, the mechanical surface disruption step can, for example, be undertaken by pressurizing selected viscoelastic surfaces with an air stream delivered continuously at a suitable pressure and temperature. At the same time, the photosensitive material is cooled from viscoelastic semi-solid to solid. Therein, the air pressure and the cooling rate can be changed to change the surface profile of the substantially concave sidewalls.

In order to form substantially convex surfaces or sloped regions with convex surfaces, the mechanical surface disruption step can, for example, be carried out by indentation of selected viscoelastic surfaces using an imprinting stamp while the photosensitive material is cooled from viscoelastic semi-solid to solid. Typically, the imprinting stamp is a glass plate photomask fabricated with solid polymeric patterns of certain thickness. The speed of the indentation and the cooling rate can be changed to change the final profile of said substantially convex surfaces. For the purposes of clarity, the mechanical surface disruption step involving an imprinting stamp is referred to hereinafter as "stamping", and the speed of indentation is referred to hereinafter as "stamping speed".

As mentioned in aforementioned step (g), the deformed surfaces resulting from the mechanical surface disruption step can then be selectively photo-polymerized by exposure through the same imprinting stamp or another photomask under a suitable light source. This step selectively cures the sloped or arbitrarily profiled regions, together with other planar regions defined by patterns in the photomask or the imprinting stamp, thereby forming the three-dimensional microstructures having sloped sidewalls and flat regions.

While the working principle of the microfabrication method disclosed in GB0408169.1 can be demonstrated manually to some extent, none of the above surface disruption techniques anticipate a highly computerized system which can effect the aforementioned microfabrication method with sub-millimetre resolution.

Engineering sidewall profile or slope of a sub-structure requires simultaneous variations in temperature of the photosensitive material and the speed of mechanical surface disruption step. According to the mathematical approximation given in UK Informal Patent Application 0408169.1, the final sidewall profile and/or slope of a to-be-formed microstructure also depends on other physical properties of the photocurable material, including, but not limited to, the temperature-dependent viscosity and structural rigidity.

Conventional two-dimensional mask-aligners, hot-plates and UV curing apparatus are known in art for general two-dimensional photolithographical processing. While these systems may be suitable for the particular purpose employed, or for general photolithographical processing, they would not be suitable for the processing a material in the third dimension.

Without a special piece of equipment, it is difficult to manually mass-fabricate a plurality of three-dimensional microstructures on a wafer with reasonable repeatability, controllability and resolution in all x-, y- and z-directions.

The resolution of fabricated microstructures is highly dependent upon the amount of vibrations self-generated within a fabrication system. The majority of the mechanical noises are generally generated from the moving parts of a system. Mechanical noises adversely affect the aforementioned processing sequence. The most affected step of the aforementioned microfabrication process is the stamping step, because this step involves direct physical contact between the photo-curable material and the imprinting stamp. For this reason, particular reference is given in this application to formation of substantially convex sidewalls, i.e. the aforementioned stamping step. However the present invention may be applied to any microfabrication process, for which mechanical noise is undesirable.

While the majority of noises come from the moving parts, mechanical noises can also be generated from high current inductive elements such as within a transformer. Heating and cooling using the aforementioned thermoelectric heat stage typically requires a substantially high current power supply. It is possible to use an industrial transformer to supply such a large current. However, following a prolonged period of operation, transformer-based high current power supplies tend to generate a large amount of heat and audiable noises (also known as flicker noises) to a workbench. Such unwanted heat and audiable noises very often cause annonyance to the users operating the proposed system. Furthermore, in many normal circumstances, a power supply is physically attached to the tuning modules of an electronic unit. High current transformer-based power supplies are also relatively bulky and heavy compared to other electronic components in the same system. If the noisy transformer-based power supply is to be physically relocated from the workbench, the tuning modules might also need to be physically re-located as well, making a manual tuning step inconvenient.

It is accordingly an object of the present invention to provide an efficient microfabrication system which permits microfabrication processes such as that disclosed in the UK Patent Application No. GB0408169.1, or the like, or else other conventional photo-lithographical processing steps, to be undertaken conveniently and inexpensively and with improved accuracy.

Conventional photo-lithographical processing steps include, but are not limited to, heating of organic materials, general mask-alignment and photo-polymerization.

According to a first aspect of the present invention, there is provided apparatus for the microfabrication of one or more microstructures, said apparatus including a first part and support means capable of supporting any or any combination of a mask, an imprinting stamp and/or a wafer in relation to said first part, and control means, wherein the support means is arranged to be selectively movable relative to said first part by way of one or more piezoelectric members under the control of the control means.

The present invention is particularly advantageous for effecting mask-alignment, mechanical surface disruption and photo-polymerization of photocurable materials by the provision of piezoelectric members to effect movement of a supporting means so as to allow relative movement between the first part and the support means substantially without generation of mechanical noise, thereby enabling profiled sidewalls of microstructures to be fabricated with submillimetre resolution.

In one embodiment, the one or more piezoelectric members includes a plurality of members forming a piezo-electric stack. Preferably the piezoelectric stack includes two or more ceramic members separated by one or more metallic electrodes. The control means may control the potential difference applied across the one or more piezoelectric members so as to effect elongation of the piezoelectric members.

According to a further embodiment, the piezoelectric member is disposed between the first part and the at least one supporting member. The piezoelectric member may be arranged to move the supporting member in either of a generally vertical, or else a generally horizontal orientation.

Preferably, the apparatus further includes a resilient member biased against the movement of the supporting member by way of the piezoelectric member. The resilient member may be a leaf spring.

In a preferred embodiment, one piezoelectric member is arranged to selectively move the supporting member in a direction substantially parallel to the movement imparted by at least one further piezoelectric member. Alternatively one piezoelectric member may be arranged to selectively move the supporting member in a direction substantially perpendiculer to the movement imparted by at least one further piezoelectric member.

In the case of supporting means for a mask and imprinting stamp, a piezoelectric arrangement allows adjustment for planarity and/or to be moved downwards over a limited distance at different speeds with resolution in the order of ten microns. Piezoelectric members can advantageously provide sufficient force to mechanically deform the semi-molten photocurable material deposited on a wafer and with the required resolution.

The apparatus may include a further movement means for coarse movement of the supporting member and the piezoelectric member provides for fine movement of the supporting member into an operative position. Preferably the piezoelectric member can move the supporting member with an accuracy in the order of one micron.

The provision of piezoelectric members in conjunction with a wafer supporting means advantageously allows fine positioning of a wafer in the x-y plane for mask-alignment and mechanical surface disruption. The further movement means may comprise a stepper motor and a belt-driven transmission box, which can be used to drive the upward or downward movements of the wafer supporting portion by way of a slider arrangement.

According to one embodiment wherein the supporting member supports a wafer, the wafer may be removably attached to the supporting member. Preferably the wafer is attached to the support member by a removable organic material. More preferably, the wafer is removably attached to a wafer holder, said wafer holder arranged to be removably mounted on the support member.

The provision of a detachable wafer holding arrangement advantageously permits a to-be-processed wafer to be detached as required or mechanically captured for any processing steps without excessively generating mechanical noises such as those generated by a conventional vacuum sucking technique. By minimizing mechanical noises, the resolution power of the proposed system can be substantially improved.

According to a preferred embodiment, one piezoelectric member is connected in parallel with at least one other piezoelectric member to the control means. Preferably a voltage amplifier is connected in series with each piezo electric member and each voltage amplifier may be associated with a corresponding voltage source.

In one embodiment, at least one lever arrangement is provided in the force path between the support means and the one or more piezoelectric members

According to a second aspect of the invention, there is provided apparatus for the microfabrication of microstructures including a body portion and two or more operative members, said body portion including a support member for supporting any or any combination of a mask, an imprinting stamp and/or a wafer, and said operative members being movable into and out of an operative position relative to the supporting member to allow said operative members to be interchangeable for operation at different stages of a microfabrication process.

Preferably the operative members are any two or more of a visualization unit, an exposure unit and/or a hot air injection unit.

The visualization unit permits alignment between the wafer and the photomask, or between the wafer and the imprinting stamp based on a microscope objective or a microscope objective coupled with a CCD camera.

In one embodiment, a first operative member is movable independently of a second operative member. Preferably a first operative member is movable within a plane which is different to a plane of motion of a second operative member. Yet more preferably still the first operative member is movable within a plane which is perpendicular to the plane of motion of the second operative member.

According to a preferred embodiment, the apparatus includes three operative members, a first operative member being movable into and out of an operative position in one plane and a second and a third operative member being movable into and out of an operative position in a second plane.

Preferably, at least one operative member is pivotally attached to the body portion and an arm may extend between the operative member and the body portion.

The hot-air-injection unit may allow a molten or semi-molten photo-curable material to be deformed by injection of an air stream maintained at a suitable air pressure and temperature. The exposure unit may be any light source capable of photo-polymerization or annealing of a photo-curable material deposited on a wafer. The control means may take the form of any system capable of generating an analogue or digital signal for control of the piezoelectric members. The control means may additionally allow control of the temperature of the photocurable material, control of the speed of mechanical surface disruption, and/or control of the pressure and temperature of the air from the hot-air-injection unit.

Particular embodiments of the invention are described in further detail below and with reference to the accompanying drawings, the components of which are not necessarily to scale, and in which:

Figures 1a to 1c illustrate the proposed microfabrication system in an alignment mode;

Figure 2 illustrates the proposed microfabrication system in a standby mode;

Figure 3 illustrates the proposed microfabrication system in an exposure mode;

Figure 4 illustrates the proposed microfabrication system in a hot-air-injection mode;

Figures 5a and 5b illustrate the thermoelectric heat stage in one preferred embodiment;

Figures 6a to 6c illustrate the circuit for driving the thermoelectric heat stage depicted in Figure 5;

Figures 7a to 7c illustrate the mask holding device in one preferred embodiment;

Figures 8a and 8b illustrate a piezo-electric stack to be used in the mask holding device;

Figures 9a to 9d illustrate the mechanism of planarity adjustment step and the stamping step undertaken in mask holding device;

Figures 10a and 10b illustrate control and amplification circuits that can be used to drive each of the piezo-electric stacks;

Figure 11 illustrates the overview of the proposed system at a system level;

Figures 12a to 12i illustrate the process sequence of mechanical surface disruption involving the imprinting stamp;

Figure 13a to 13g illustrate the process sequence of mechanical surface disruption involving hot air injection;

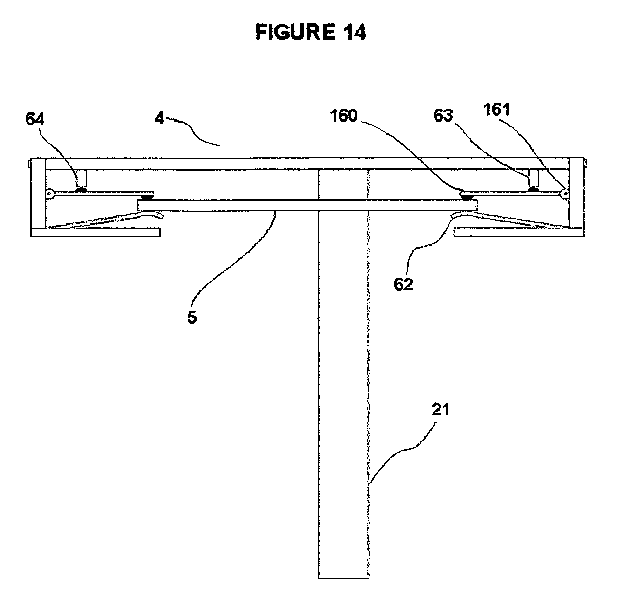

Figure 14 shows an alternative mask holding device arrangement including levers; and

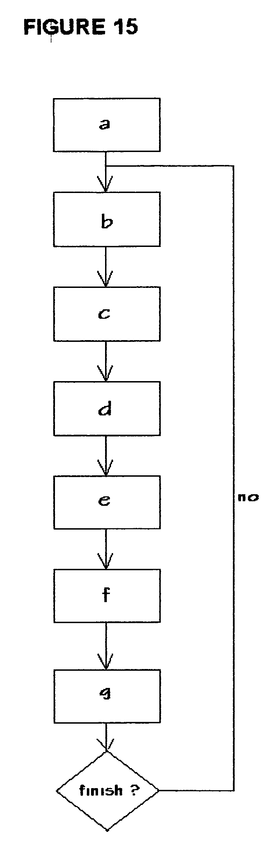

Figure 15 illustrates the basic process flow of the three-dimensional microfabrication method as disclosed in UK Informal Patent Application GB0408169.1.

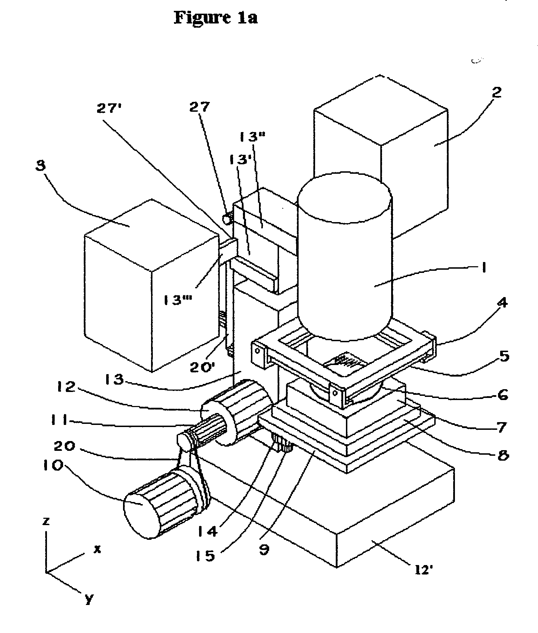

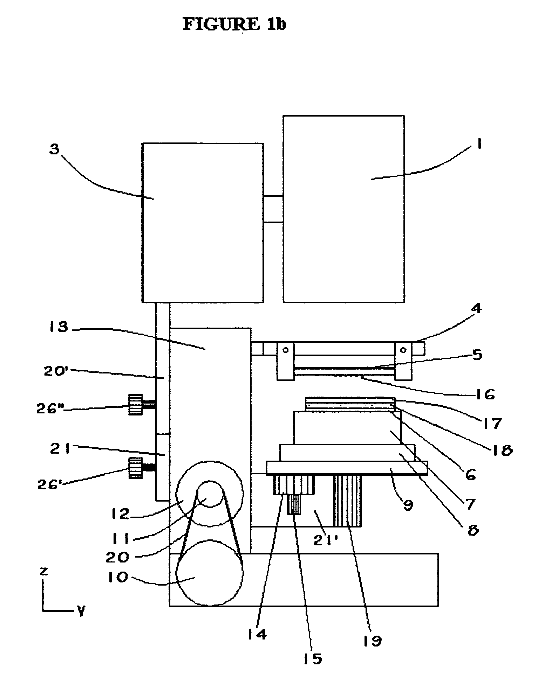

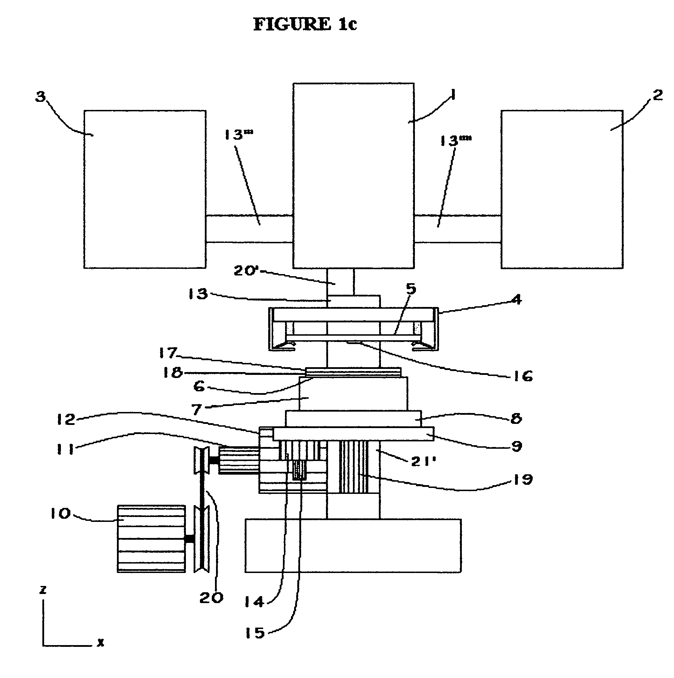

Reference is herein made to to Figures 1, wherein Figure 1a, Figure 1b, and Figure 1c respectively show the perspective view, the side view and the front view of a microfabrication apparatus according to the present invention.
The embodiment shown in Figure 1 employs a mask holding device 4 for supporting either a photo-mask or an imprinting stamp 5 fabricated with polymeric indentors of certain thickness. Herein, the imprinting stamp 5 is to be used as a master mould for the aforementioned stamping step.
Referring to Figure 1, wafer 18 is deposited with a photocurable material 17 and is mounted onto a detachable wafer holder 6. Preferably, the wafer 18 is mounted by means of adhesion using an organic material such that, during the microfabrication process, the bottom surface of wafer 18 is temporarily adhered to the upper surface of the detachable wafer holder 6. This organic material is preferably a removable organic material such as a positive photoresist, a removable carbon gel, removable epoxy and/or the like. The provision of this technique to hold the wafer in position, instead of the commonly used vaccuum sucking technique, minimizes unwanted vibrations from the vacuum pump that can adversely affect the resolution power of the proposed system.
Referring to Figure 1, the detachable wafer holder 6 can be mounted on or dismounted from the thermoelectric heat stage 7 for other processing steps. During the microfabrication process, the detachable wafer holder 6 is mechanically captured on the thermoelectric heat stage 7 by means of screw-lead arrangements or magnet-screw arrangements. Upon completion of all the required processing steps, the detachable wafer holder 6 can be unmounted and the wafer 18 therein can be released from the detachable wafer holder 6 by soaking the same in an appropriate solvent.
Referring to Figure 1, the thermo-electric heat stage 7 is capable of changing the temperature of the photocurable material 17 at any rate to any value within a pre-defined temperature range. Perferably, the rate of the temperature change and the temperature range can be pre-set or programmed in accordance to the physical properties of the photocurable material 17.
Referrring to Figure 1, the thermo-electric heat stage 7 is supported on a piezo-electric x-y positioning table 8, on which the supported objects above can be moved or positioned with respect to the mechanical x-y positioning table 9 underneath. Typically, if the piezo-electric x-y positioning table 8 is a commercial grade piezo-electric x-y positioner, positioning of the photocurable material 17 can be readily attained in the x- and y- directions with resolution in the order of one micron. Typically, the piezo-electric x-y positioning table 8 is electrically driven using a piezo-electric amplifier.
Referring to Figure 1, the mechanical x-y positioning table 9 supporting the piezo-electric x-y positioning table 8 is used to provide coarse positioning in x-y plane with respect to the base (12' of Figure 1a). The mechanical x-y positioning table can be used to provide coarse positioning of photocurable material 17 in the x-direction via the x-positioning knob 14 and/or in the y-direction via the y-adjustment knob 15. In addition, the mechanical stage 9 also contains a mechanical rotary shaft 19 underneath, which can be used to adjust the angular displacement of the photo-curable material 17. Preferably, positioning of the photocurable material 17 using the mechanical x-y positioning table is either manually operated or motor-driven using stepper motor and belt-driven transmission box arrangements.
For the purposes of clarity, the detachable wafer holder 18, the thermoelectric heat stage 7, the piezo-electric x-y positioning table 8 and the mechanical x-y positioning table 9 are collectively referred as "wafer supporting portion" hereinafter.
As shown in Figure 1b, the aforementioned wafer supporting portion and the mask supporting device 4 are respectively attached to mechanical sliders 20' and 21. The mechanical sliders 20' and 21 respectively allow the aforementioned wafer supporting portion and the mask supporting device 4 to be moved downwards or upwards or clamped in a fixed aptitude. Typically, such upwards or downwards movements is achievable with resolution in the order of 100 microns or better.

Preferably, the upwards and downwards movements of the wafer supporting portion is driven by a drive mechanism comprising a stepper motor 10, belt-driven transmission box 11', and fine-adjustment knob 11. The stepper motor 10 can be electronically controlled by another piece of firmware or hardware (not shown) which may be interfaced to a computer.

Referring to Figure 1, the proposed embodiment comprises a visualization unit 1, an exposure unit 2 and the hot-air-injection unit 3. The visualization unit 1, the exposure unit 2 and the hot-air-injection unit 3 are connected via pivot joints to supporting member 13", which is attached to a slider 20'. This arrangement permits the visualization unit 1, the exposure unit 2 and the hot-air-injection unit 3 to be moved upwards or downwards. The provision of slider 20' permits focus adjustment of the visualization unit.

Preferably, the upwards and downwards movements of the functional units (units 1, 2, and 3) are either manually operated or motor-driven using a stepper-motor/transmission-box arrangement or manually operated, via the adjustment knobs 26" as illustrated in Figure 1b. Such movements can be attained with resolution determined by the resolution power of slider 20'. Typically, a commercial grade mechanical slider can offer a resolution up to 10 microns per graduation.

As shown in Figure 1, the visualization unit 1 is preferably a microscope objective or a microscope objective coupled with a CCD camera. The visualization unit allows the photomask/imprinting-stamp or the photocurable material to be visually examined, preferably in sub-millimeter or sub-micron resolution.

The exposure unit 1 is preferably a conventional light source (not shown) embedded in a light barrel (not shown), such that the light from the said light source emits a light capable of photo-polymerizing the photocurable material 17. Preferably, the light barrel contains optical devices which enable the light from the said light source to be evenly distributed over the entire area of the wafer 6. The wavelength of the light to be required depends on the properties of the photocurable material 17 forming the microstructure(s). By way of example, the said light source can be an ultra-violet light source based on a high-pressure mercury lamp if the photocurable material 17 is curable in ultra-violet light frequencies.

As shown in Figure 1, the hot-air-injection unit 3 is preferably capable of injecting an air stream at any required temperature and pressure. The hot-air-injection unit 3 is intended for forming substantially concave sidewalls. The air stream leaving from the hot-air-injection unit 3 is used to pressurize and deform the photocurable material 17 while the photocurable material 17 is being cooled from semi-molten state to solid state. Through a substantially soft vinyl duct, the hot-air-injection unit is connected to another unit (not shown) containing a mechanical arrangement (not shown) which permits air to be blown and passed through a heating element embedded within the hot-air-injection unit. The mechanical vibrations as a result of the pressure fluctuations of the air current therein do not overly affect the resolution power of the proposed system.

As illustrated in Figure 1, the proposed system comprises pivot joints 27, 27' and 27" which respectively permit the microscope unit 1, the exposure unit 2 and/or the hot-air-injection unit 3 to be suitably angled, swapped in position, and/or re-configured to different modes, depending on the application requirements. These modes are "alignment mode", "standby mode", "exposure mode" and "hot-air-injection" mode. It will be appreciated that the arrangement of pivot joint 27 is perpendicular to the pivot joints 27' and 27". This allows the microscope unit 1 to be rotated into and out of an operation condition about an axis which is perpendicular to the axis of rotation of the exposure unit 2 and the hot-air-injection unit 3 (i.e. the microscope unit 1 moves in a substantially vertical plane, whereas the exposure unit 2 and hot-air-injection unit 3 both move in a substantially horizontal plane).

The system shown in Figure 1 is pre-configured to the "alignment mode", wherein the visualization unit 1 is projected onto the photocurable material 17. This arrangement allows the photomask 5 or the photocurable material 17 underneath the photomask be visually examined in sub-millimeter resolution. Hereinafter, the "alignment mode" is referred as a configuration for visualization, whilst the mask-alignment step and the stamping step is undertaken.

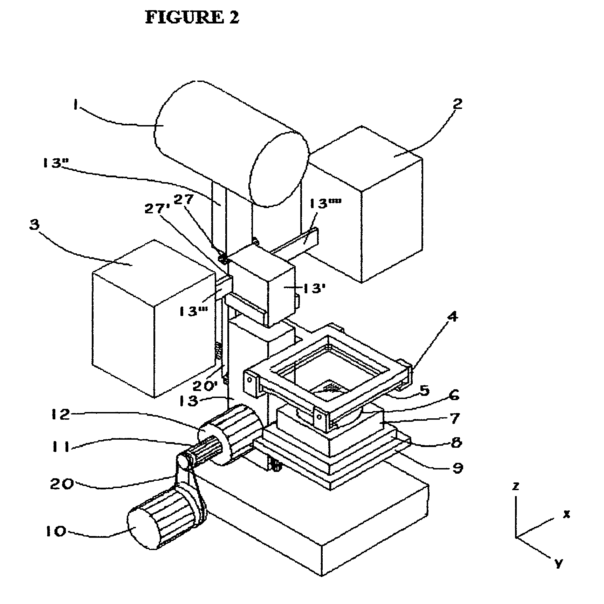

As shown in Figure 1a, pivot joint 27 is coupled between the supporting member 13' and metal arm 13" having one end attached to the visualization unit 1. This arrangement allows the visualization unit to be lift upwards in a manner illustrated in Figure 2. The configuration as shown in Figure 2 is hereinafter referred as "standby mode". In this mode, no functional unit is projected onto the photocurable material 17. The "standby mode" is intended for standby operation or idle condition and allows easier access to the mask holding device 4, the stamp 5 and wafer holder 6.

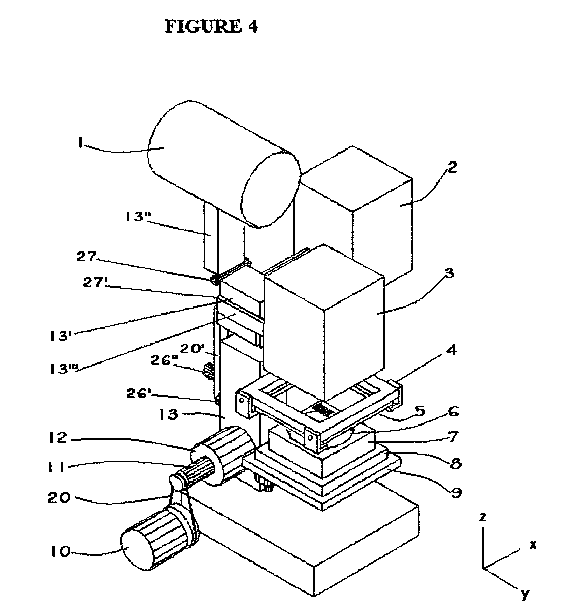

As shown in Figure 1, pivot joint 27' is coupled between the supporting member 13' and metal arm 13''' having one end attached to the hot-air-injection unit 3. This allows the hot-air-injection unit 3 to be suitably angled such that the hot-air-injection unit 3 is projected onto the photocurable material 17, as illustrated in Figure 4. The configuration as shown in Figure 4 is hereinafter referred as "hot-air-injection mode". In this mode, air stream from the hot-air-injection unit 2 can be injected onto the photocurable material at any required pressure and/or temperature. The "hot-air-injection mode" is intended for drying of organic materials or for the mechanical surface disruption step involving injection of hot air.

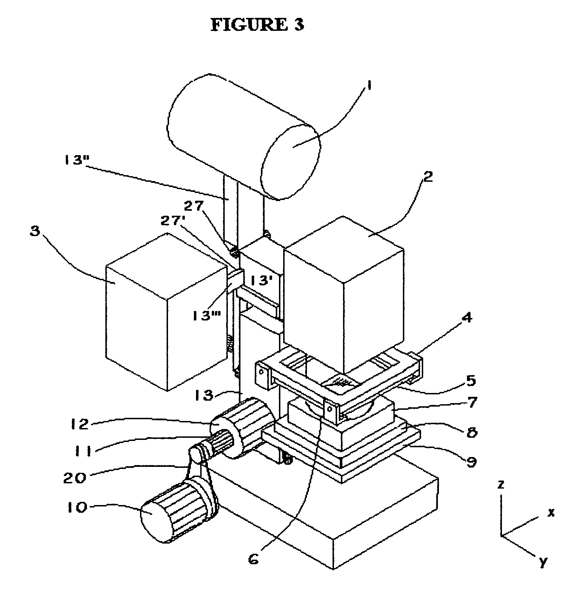

Likewise, there is another pivot joint similar to pivot joint 27" (not shown in any accompanied figure) which is coupled between supporting member 13' and metal bar (13"" of Figure 2) having one end attached to the exposure unit 2. This arrangement allows the exposure unit 2 to be suitable angled such that the exposure unit 2 directly projects onto the photocurable material 17, as illustrated in Figure 3. The configuration as shown in Figure 3 is hereinafter referred as "exposure mode". In this mode, the photocurable material 17 can be exposed to the light source embedded in the exposure unit 2. The "exposure mode" is intended for annealing or photopolymerization of the photocurable material 17.

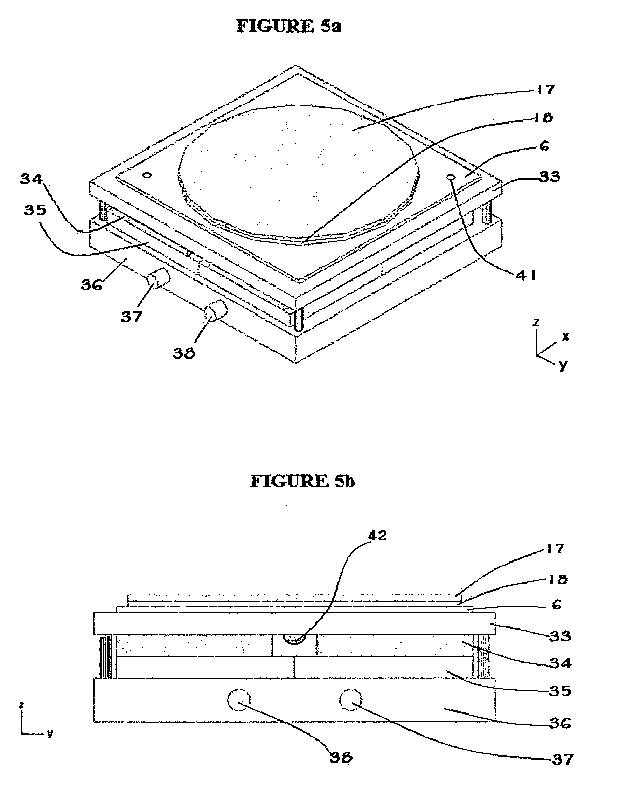

Referrence is herein made to Figure 5, wherein Figures 5a and 5b respectively illustrate the perspective view and the front view of the aforementioned thermoelectric heat stage 7. The thermoelectric heat stage 7 is used for heating or cooling of the photocurable material deposited on the wafer. The rate of the temperature change in the photocurable material 17 can also be changed therein.

As illustrated in Figures 5, the thermoelectric heat stage comprises a resistive heating module 34 for joule heating of the photocurable material 1.7, a Peltier element 35 for thermoelectric cooling of the photocurable material 17, a temperature sensor 42 for sensing the temperature of the photocurable material 17 and a water block 36 for removal of surplus heat generated by the Peltier element 35 and the resistive heating element 34.

Referring to Figure 5, the maximum power at which the Peltier element 35 can operate is preferably at least 110 watts. The maximum temperature at which the Peltier element 35 can operate is preferably at least 120 degree centrigate.

Perferably, as illustrated in Figure 5b, the cold side of the Peltier element 35 is placed in close contact with the resistive heating module 34 (i.e. faces upwards), whilst its hot side is placed in close contact with the water block 37. Tap water is flowing continuously through the water block 37 during the mechanical surface disruption step.

As shown in Figure 5b, the temperature sensor 42 is physically attached to the lower surface of the metal plate 33. This arrangement allows the temperature of the photocurable material 17 to be monitored and translated into equivalent electrical quantity such as resistance, voltage and/or current. Typically, the temperature sensor 42 can be a ceramic-like thermistor having temperature-dependent resistance. The use of thermistor as a temperature allows resolutions of +/- 0.1 °C to +/- 0.2 °C to be archieved. Alternatively, the temperature sensor can also be current-mode temperature sensing device wherein its electrical current is a function of its body temperature.

Preferably, as shown in Figure 5b, the resistive heating module 34 is constructed from a network of resistive elements capable of releasing heat in excess of 70 watts and operating at any temperature between 20 °C and 200 °C.

Preferably, as shown in Figure 5b, the resistive heating module 34, the Peltier element 35, the temperature sensing device 42 and the water block 36 are mechanically captured using metallic screw-lead arrangements and glued together using a thermal conductive compound. The provision of thermal compound can heighten the thermal conductivity of the thermoelectric heat stage and minimize any delay in settling the temperature of the photocurable material 17 to a final value.

To heat a photocurable material 17 on the wafer 18, as shown in Figure 5b, the resistive heating module 34 is switched on, while the Peltier element 35 is switched off. During this process, the resistive heating module 34 releases heat to the photocurabe material. The temperature of the photocurable material 17 continues to increase, until the temperature readout from the temperature sensing device 42 reaches a required value.

Conversely, to cool the photocurable material 17 on the wafer 18, the resistive heating module 34, as shown in Figure 5b, is switched off, while the Peltier element 35 is switched on. During this process, the surplus heat which remains in the resistive heating module 34 and the photocurable material 17 is then released through the Peltier element 35 to the water block 36. The temperature of the photocurable material 17 continues to decrease, until the temperature readout from the temperature sensing device 42 reaches a required value.

As shown in Figure 5, water in the water block 36 is continuously running throughout the process in order for the surplus heat to be released from the Peltier element 35 and the resistive heating module 34.

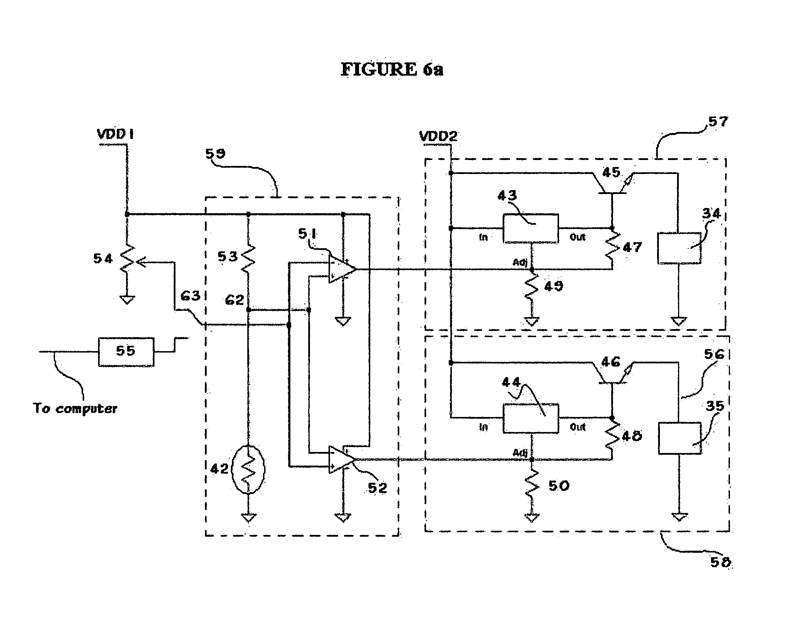

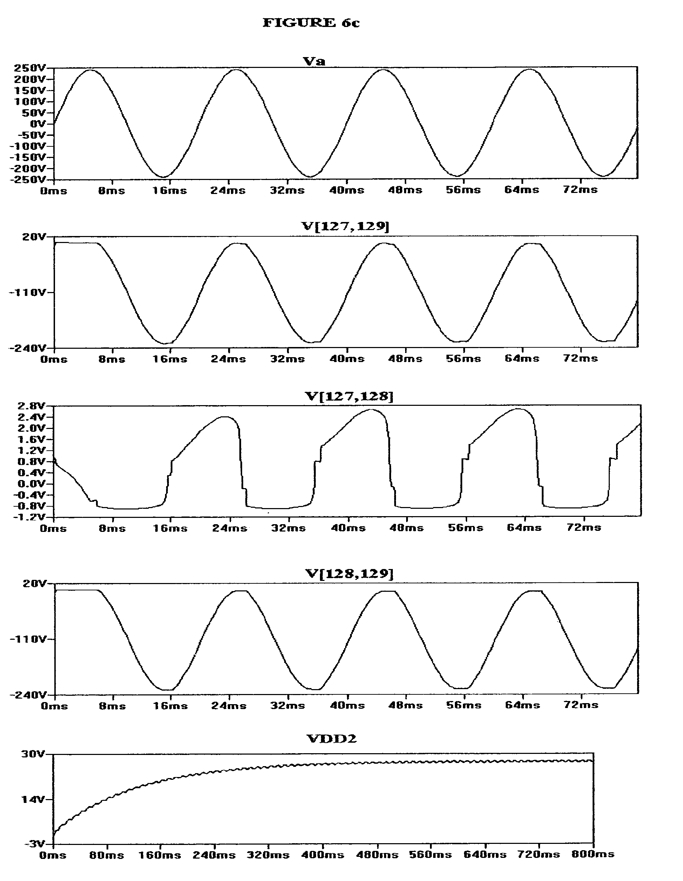

The aforementioned temperature control mechanism is preferably undertaken using an appropriate electronic control unit. Preferably, the thermoelectric heat stage is capable of rapidly changing the temperature of the photocurable material 17. In one preferred embodiment, the electronic control unit is implemented in the form of a bang-bang temperature controller as illustrated in Figure 6a.

In the circuit shown in Figure 6a, blocks 57 and 58 are two topologically identical circuits respectively responsible for supply of regulated current to resistive heating element 34 and Peltier element 35. Blocks 57 and 58 can be respectively switched on and off by the logic outputs of comparator 51 and comparator 52.

When cooling of the photocurable material 17, the output of comparator 51 is set at logic low. This condition switches off block 58, thus discontinuing supply of current to heating element 34. At the same time, the output of comparator 52 is set at logic high. This condition switches on the block 58, leading to current flow in the peltier element 35.

Likewise, when heating of photocurable material 17, output of comparator 52 becomes is set at logic low. This condition switches off block 58, which in turn discontinues supply of current to Peltier element 35. At the same time, the output of comparator 51 is set at logic high. This condition switches on the block 57, leading to current flow in the resistive heating element 34.

The active devices governing the performance of block 57 are a standard 3-terminal voltage regulator 43 and a power transistor 45. Typically, this 3-terminal voltage regulator 43 is an off-the-shelf adjustable voltage regulator integrated circuit LM317T manufactured by National Semiconductor Corparation. Typically, transistor 45 is an off-the-shelf npn transistor 2N3055 manufactured by ST-Thomson, capable of conducting at 60 amps when the voltage across its base terminal and emitter terminal exceeds its switching threshold voltage. The output voltage of the regulator 43 is set by two resistors 47 and 49, such that R2 is the measured resistance between the Adj pin of voltage regulator 43 and the ground, and R1 is the measured resistance between between the Adj pin and the Out pin of voltage regulator 43. The voltage across R1 is a constant 1.25 volts and the adjustment terminal current is typically less than 100uA. The voltage at Out pin of voltage regulator 43 can be closely approximated from Vout=1.25 * (1+(R2/R1)) which ignores the Adj terminal current but will be close if the current through R1 and R2 is many times greater. Therein, the power transistor 45 is used to share the portion of total current to be required by the heating element 34, which usually consumes in excess of 1.5 amps of current. The amount of current sharing is established with the collector terminal of the power transistor connected to the In terminal of voltage regulator 43 and with the base terminal of the power transistor 45 connected to the Out terminal of voltage regulator 43. Typically, the voltage regulator, i.e. LM317T, will provide over 1 amp of current to drive the base of the pass transistor. Assuming a gain of 10 in power transistor 45, block 57 should be capable of delivering 7 amps or more to resistive heating element 34.

Referring to Block 57 shown in Figure 6a, power transistor 45 will stop conducting when the voltage drop between its base terminal and its collector terminal falls below the switching threshold voltage of power transistor 45. According to the aforementioned approximation Vout=1.25 * (1+(R2/R1)), power transistor 45 will stop conducting when there is a virtual short circuit at Adj pin of voltage regulator 43, i.e. R2=0. The condition of R2=0 can be readily achieved by having the output of comparator 51 set to logic zero (i.e. virtual ground at Adj pin). Likewise, power transistor 45 starts conducting at a current determined by the voltage drop between the base and the emitter of power transistor, only when this voltage drop exceeds the switching threshold voltage of power transistor 45. According to the aforementioned approximation Vout=1.25 * (1+(R2/R1)), this condition happens only when the output of comparator 51 is at logic high (i.e. high impedance).

In common with block 57, block 58 employs basically the same operating principle to power the load, which is the peltier element 35. That is, power transistor 46 will start conducting when the output of comparator 52 is at logic high (i.e. high impedance). Likewise, power transistor 46 will stop conducting when the output of comparator 52 is at logic zero (i.e. virtual short circuit at the Adj pin of voltage regulator 44). The circuit topology of block 58 is by virtual identical to that of block 57. However, the passive elements may differ in values because of the difference in the loading requirements between the peltier element 35 and resistive heating element 34.

The cooling and heating mechanism is usually undertaken using the sensing block 59. Thermistor 42 is connected with resistor 53 to form a potential divider configuration. The reference temperature representing the desired temperature of the photocurable material 17 is either manually set in potentiometer 54 or digitally set at the input of the digital-to-analog converter 55. The actual temperature of the photocurable material 17 is monitored and translated by thermistor into an equivalent resistance which, together with resistor 53, forms a temperature-dependent voltage at net 62. This temperature-dependent voltage is then compared by comparators 51 and 52 with the voltage captured at switch 63 so as to determine whether the temperature of photocurable material 17 has fallen below the desired temperature (i.e. reference temperature). When the actual temperature of the photocurable material 17 falls below the reference temperature as captured in switch 63, comparator 51 will generate logic high in the output, whilst comparator 52 will output logic zero. This condition will switch off block 58 and switch on block 57, thus activating the heating process. In contrast, if the actual temperature of the photocurable material 17 rises above the reference temperature, comparator 51 will output logic zero, while comparator 52 will output logic high. This condition will switch on block 58 and switch off block 57, thus activating the cooling process.

While the reference temperature can be manually pre-set and changed in analog domain using the variable resistor 54, it can also be digitally programmed. Therein, the temperature of the photocurable material is read by thermistor 42, translated into an equivalent voltage at net 62 and compared with the analog output from the digital-to-analog converting stage 55. Such an arrangement allows the temperature of the photocurable material 17 to be maintained and manipulated in digital domain using a computer or similar digital processing device.

The circuit shown in Figure 6a is a bang-bang temperature controller with no integral or differential terms added. Unavoidably, there will be an offset between the target and stable temperatures and this offset is usually slow to settle. However, the thermal time constant of the photocurable material is typically large, in the order of many minutes.

One of the requirements for effecting the mechanical surface disruption step is to be able to heat or cool the photocurable material 17 rapidly, typically at a rate comparable to the stamping speed. To meet this requirement, the heating element and the cooling element are usually required to operate at a very large current, usually in excess of 5.0 amps over an output range of 1.5 to 36 volts. Preferably, the power supply to VDD2 should be large enough so that the peak input voltage to the regulator remains 5.5 volts above the output at full load. This allows for a 3 volt drop across the voltage regulator LM317T, plus 1 volt of ripple produced by the filter capacitor.

The power requirement at VDD2 can be readily met by provision of a heavy duty power supply capable of generating current in excess of 2 amps over a voltage range from 1.25 volts to 20 volts. Conventional power supply circuits are mostly implemented using a industrial transformer. Whilst industrial transformers perform satisfactorily in many applications, they often suffer from many drawbacks which warrant further improvement. Very often, after a prolonged period of operation, the power transformer operating at such a high current tends to generate a large amount of heat and audiable noises more easily than other electronic components in the same system. Such unwanted heat and audiable noises very often cause annonyance to the user(s) operating the proposed system. To overcome this problem, VDD2 can be driven by a power supply having no transformer (i.e. transformerless power supply).

In many prior examples, a transformerless power supply is usually implemented using one or more class X2 metallised polypropylene capacitors for AC coupling in the input stage. These metallised polypropylene capacitors generally can operate at high voltage, but offers relatively low capacitance. The maximum current at which the transformerless power supply circuit can operate is roughly proportional to the combined capacitance of these capacitors. Because of the low capacitance nature of metallised polypropylene capacitors, not many conventional transformerless power supply circuits are suitable for high current operation.

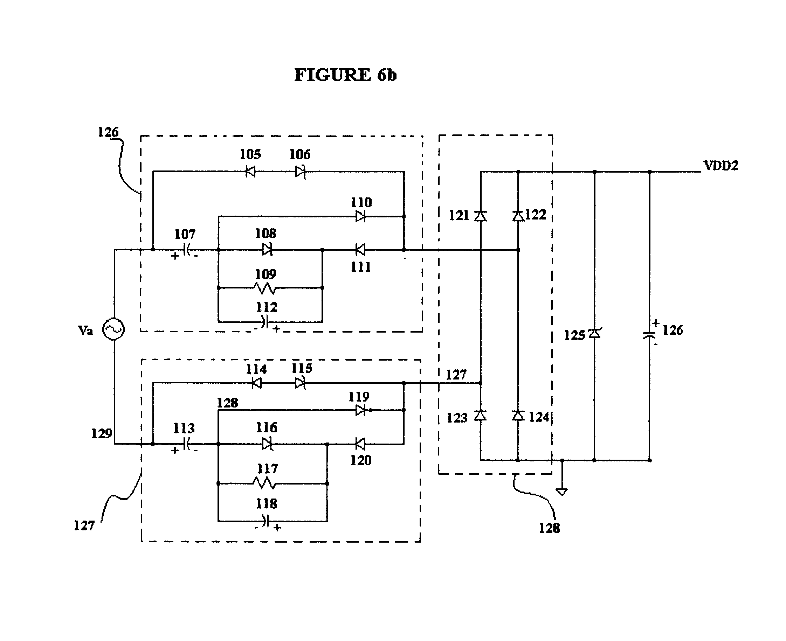

The problem can be overcome by provision of a specially designed transformerless power supply as shown in Figure 6b, having:

a) filtering blocks 126 and 127 in the input stage wherein electrolytic capacitors are used for capacitive-coupling of positive and negative half cycles of the input AC voltage, Va;

b) a full-wave rectifying section 128 which rectifies the filtered voltage from the filtering blocks 126 and 127 into a DC voltage;

c) a zener diode 125 which limits the output voltage to a required value; and

d) an output filtering capacitor 126 which removes the voltage ripples from said DC voltage.

The transformerless power supply as shown in Figure 6b can be understood by considering a complete cycle of operation. Therein, the transformerless power supply is fed with an household AC voltage, Va, having amplitude at Vp and frequency at 50 Hz. For the purposes of clarity, the direction of current flow in diode 114 when diode 114 is connected in forwards bias is considered hereinafter positive. Likewise, the voltage associated with the forwards direction of current flow in diode 114 is considered hereinafter as being positive.

During the positive half cycle of Va, diode 105 becomes reverse biased, whilst zener diode 106 is forwards biased. The current flow through diode 105 and zener diode 106 is limited to the leakage current of diode 105. However, the voltage across diode 105 and zener diode 106 can be any value between 0 and Vp. Such an arrangement makes filtering block 126 conducting during the positive half cycle. Therein, the way in which diode 110 and diode 111 are connected allows virtually no positive current to pass through electrolytic capacitor 112. Consequently, electrolytic capacitor 107 is positively charged with the positive half cycle of voltage Va, whilst electrolytic capacitor 112 is nonconducting with potential difference virtually zero.

In contrast, during the positive half cycle of Va, diode 114 is forwards biased whilst zener diode 115 is reverse biased. The voltage across diode 114 and zener diode 115 is positive with value approximately at the breakdown voltage of zener diode 115, Vb. Under such an arrangement, the voltage across filtering block is +Vb. Filtering block 127 are designed in such a way that electrolytic capacitor will not be reversely charged up with this voltage (i.e. +Vb). During the positive half cycle, the way in which diode 119 and diode 120 are connected allows current to pass through electrolytic capacitors 118 and electrolytic capacitor 113. However, the parallel connection of zener diode 116, resistor 117 and electrolytic capacitor 118 generates a phase split between voltage and current. The resistance of resistor 117 is chosen such that this phase split is just large enough to protect electrolytic capacitors 113 and 118 from being charged with reverse polarity.

Since filtering blocks 126 and 127 are topologically identical, the operation of the negative half cycle can be understood in the similar manner. During the negative half cycle, diode 114 becomes reverse biased, whilst zener diode 115 is forwards biased. The current flow through diode 114 and zener diode 115 is limited to the reverse saturation current of diode 114. However, the voltage across diode 114 and zener diode 115 can be any value between 0 and -Va. Such an arrangement makes filtering block 127 conducting during the negative half cycle. Therein, the way in which diode 119 and diode 120 are connected allows virtually no negative current to pass through electrolytic capacitor 113. Consequently, electrolytic capacitor 113 is positively charged with negative half cycle of voltage Va, whilst electrolytic 118 is nonconducting with potential difference virtually zero.

In contrast, during the negative half cycle, diode 105 is reverse biased whilst zener diode 106 is forwards biased. The voltage across diode 105 and zener diode 106 is negative with magnitude approximately equal to the breakdown voltage of zener diode 106, Vb. Under such an arrangement, the voltage across filtering block 126 is now -Vb. In common with filtering block 127, filtering block 126 are also designed to protect electrolytic capacitor 107 from being reversely charged up with this voltage (i.e. Vb). During the negative half cycle of Va, the way in which diode 110 and diode 111 are connected allows current to pass through both electrolytic capacitors 112 and 107. However, the parallel connection of zener diode 108, resistor 109 and electrolytic capacitor 112 generate a phase split between the voltage and current. The resistance of resistor 109 is chosen such that this phase split is just large enough to protect electrolytic capacitors 107 and 112 from being charged with reverse polarity.

In Figure 6b, the value of electrolytic capacitor 112 (or 118) should be large enough to prevent current overflow in diode 105 (or 114). As a rule of thumb, one can select the value of electrolytic capacitor 112 (or 118) to be five times the value of electrolytic capacitor 107 (or 113). Such an arrangement prevents thermal damage of diode 105 during the negative half cycle of Va (or of diode 114 during the positive half cycle of Va).

The transformerless power supply as shown in Figure 6b does not overly generate unwanted heat and noises. Most of the unwanted heat is generated in zener diode 125. The unwanted heat in zener diode 125 is noticeable only when the transformerless power supply is unloaded or under-loaded. To avoid thermal damage of zener diode 125, the power which zener diode 125 can tolerate is preferably up to 75 watts. Typically, zener diode 125 can be an off-the-shelf component, such as BZY91-C10 supplied by Farnell Limited.

In Figure 6b, diodes 121, 122, 123 and 124 are preferably high current rectifying diodes. Diodes 121, 122, 123 and 124 can also be substituted with an "off-the-shelf" high current bridge rectifier with forwards current above 20 amps, such as GBPC3504 manufactured by VISHAY.

Figure 6c shows the simulated waveforms at different points of the transformless power supply shown in Figure 6b. V[127,129] represents the voltage between net 127 and 129, V[127,128] represents the voltage between net 127 and 128, V[128,129] represents the voltage across electrolytic capacitor 113 as shown in Figure 6b, and VDD2 is the simulated output generated by the power supply circuit as shown in Figure 6b. The condition giving rise to this VDD2 waveform is: the capacitance for capacitors 107 and 113 is set to 470uF, the capacitance for capacitors 112 and 116 is set to 4700uF, and the output resistance at VDD2 is set to 3 ohms. Herein, the VDD2 waveform is given for illustration purpose only, and it is by no means a typical voltage for all operating conditions.

In this invention, although the transformerless power supply shown in Figure 6b refers almost exclusively for DC power supply at high current applications, it will be appreciated by those skilled in art that this circuit can be applied to other electronic circuits that operate at low voltages (i.e. typically below 50 volts).

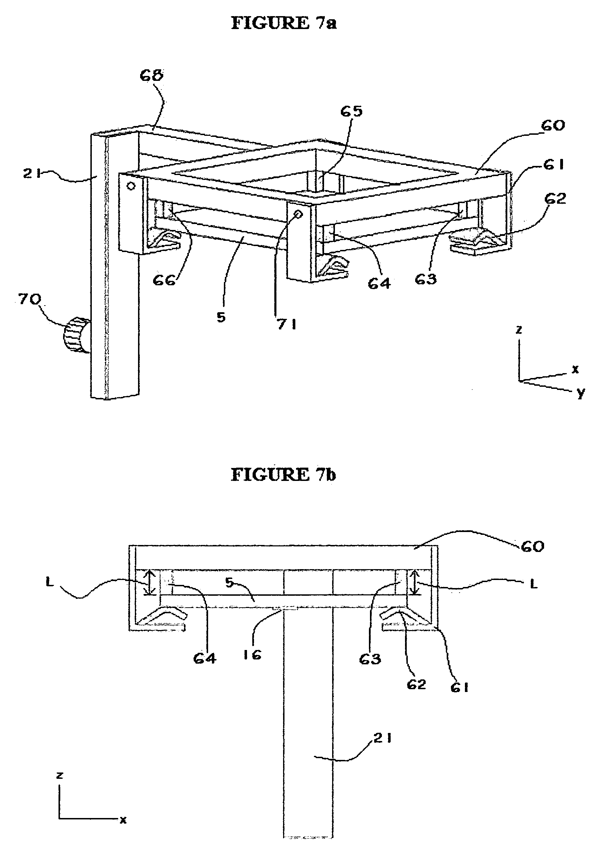

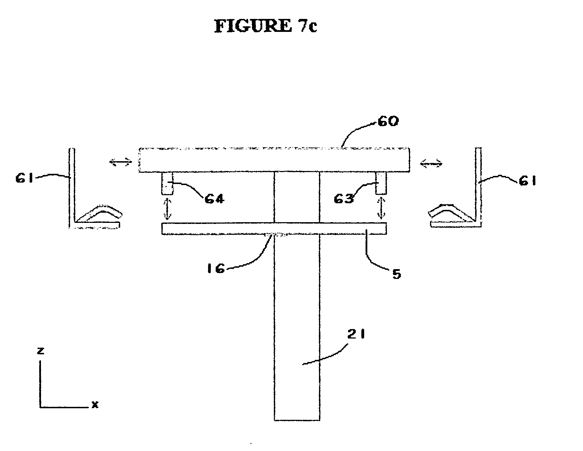

Refference is now made to Figure 7, wherein Figure 7a, Figure 7b and Figure 7c illustrate the perspective view, the front view and the disassembled view of the aforementioned mask holding device 4. The mask holding device comprises a rectangular metallic frame 60 wherein a photomask or an imprinting stamp 5 can be mechanically captured in such a way that the photo-mask or the imprinting stamp 5 receives at least a part of light from a light source for exposure. Without a photomask or an imprinting stamp 5, the aperture of the metallic frame 60 allows the air stream from the hot-air-injection unit 3 to flow through during the mechanical surface disruption step involving hot-air-injection.

In one preferred embodiment, as shown in Figure 7, the mask holding device 4 comprises four identical piezo-electric stacks 63, 64, 66 and 65 arranged vertically and mounted in the four corners of the mask holding device such that each of these piezo-electric stacks has the upper end adhered to the metallic frame 60, usually using an organic epoxy, and the lower end rests on the photomask or imprinting stamp 5.

As shown in Figure 7a and Figure 7b, the photomask or imprinting stamp 5 is supported by four buffering members 62, 62', 62" and 62'" in the four lower corners of the mask holding device 4. In this way, each of the four corners of the photo-masks or imprinting stamp 5 is sandwiched between its respective piezo-electric stack above and its respective buffering member underneath. These buffering members (i.e. buffering members 62, 62', 62" and 62'") can be springs or the like attached in four corners of the metallic frame 60. These buffering members (i.e. buffering members 62, 62', 62" and 62'") are capable of offsetting the elongation generated by any of these piezoelectric stacks (i.e. stacks 63, 64, 65, and 66). This arrangement is intended for processing steps involving the use of a photo-mask or an imprinting stamp, such as the aforementioned mask-alignment step and the stamping step.

Preferably, the mask holding device 4 can be disengaged in a manner as illustrated in Figure 7c, wherein the photomask or imprinting stamp 5 can be detached from the mask holding device 4. This arrangement is intended for processing steps not involving the photomask or imprinting stamp 5.

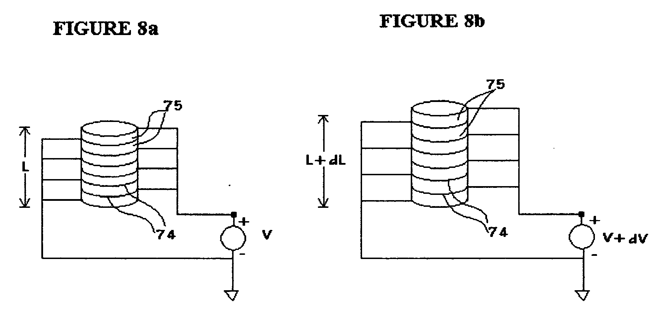

The inner structures of each piezo-electric stack, as illustrated in Figure 8, comprises a stack of ceramic disks 75 separated by thin metallic electrodes 74. When a voltage is applied to these metallic electrodes 74 in a manner as illustrated in Figure 8a, the voltage V will be transformed into precisely controlled elongation L. As shown in Figure 8b, when the applied voltage V is increased to V+dV, the length of piezoelectric stack increases from L to L+dL. Typically, under an unloaded condition, such an elongation is roughly proportional to the number of said ceramic disks times the voltage applied to the piezo-electric stack. Subject to the dielectric breakdown of the ceramic disks, the maximum elongation of a piezoelectric stack is typically 0.1 % of its length.

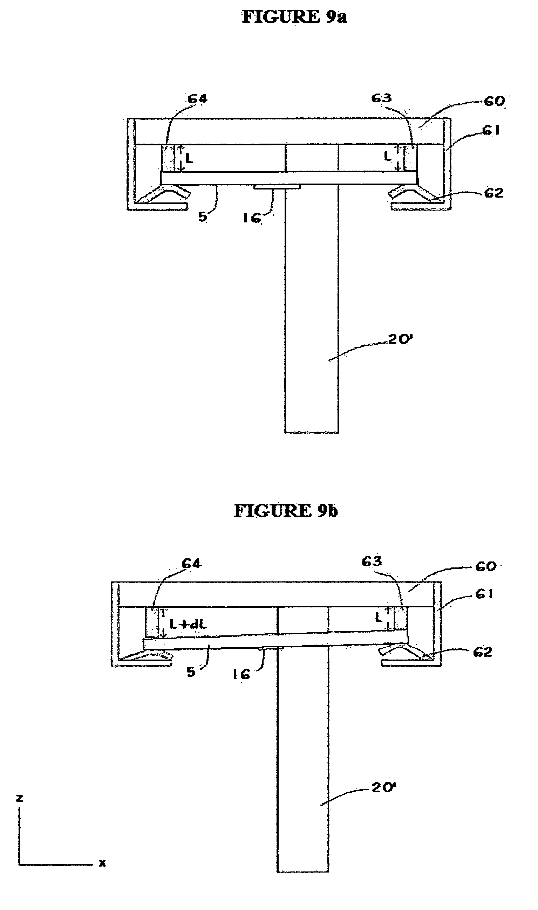

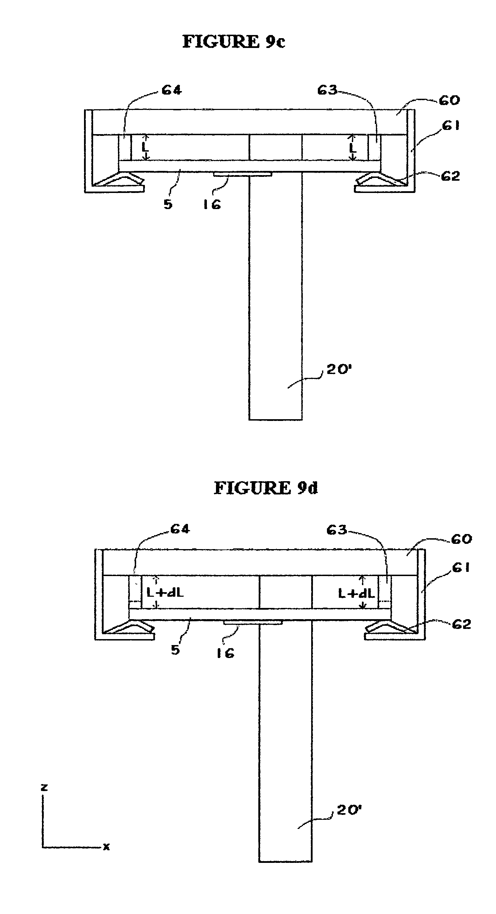

Reference is herein made to Figure 9a and Figure 9b, which illustrates a the mechanism of planarity adjustment in the mask holding device 5. As shown in Figure 9a, the mask holding device 5 is originally maintained in a condition illustrated in Figure 9a, wherein the length of each piezo-electric stack is initially L. As shown in Figure 9b, the voltage applied to piezo-electric stack 63 is now increased such that the length of piezo-electric stack 64 is elongated from L to L+dL, while the condition of piezo-electric stack 63 remains unchanged. Because the elongation of piezo-electric stack 64 is now greater than that of piezo-electric 63, the planarity of the photo-mask or imprinting stamp 5 is no longer in line with metallic frame 60. With this rationale in mind, the piezoelectric stacks in the other three corners can be similarly actuated by appropriate voltages necessary to adjust the planarity of the photomask or imprinting stamp 5.

Reference is herein made to Figure 9c and Figure 9d, which illustrate the mechanism of the stamping step performed in the mask holding device 5. The mask holding device 5 is originally maintained in a condition illustrated in Figure 9c, wherein the length of each piezo-stack is initially L. As shown in Figure 9d, if the voltages to be applied to all these piezoelectric stacks are increased synchronously by the same voltage, all four corners of the imprinting stamp will be shifted downwards by roughly the same displacement. The voltages applied to these piezoelectric stacks can be increased slowly, abruptly, or in any other manner necessary to generate a downwards movement of the imprinting stamp at a required speed. Because of the substantially vibration-free nature of the piezoelectric stacks, such a downwards movement can be typically undertaken with a resolution in the order of one micron.

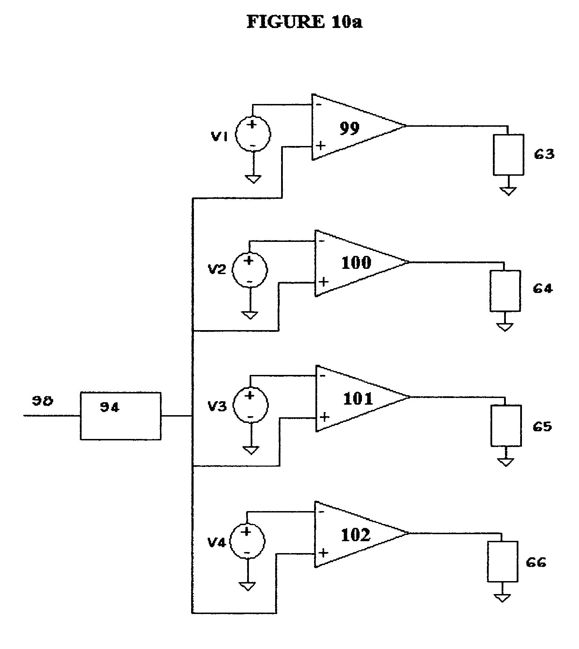

The aforementioned planarity adjustment step and stamping step can be undertaken simultaneously and intelligently using an appropriate electronic control module. Preferably, the said electronic control module is equipped with a standard interface connected to a computer or a programmable processing unit. One example of this electronic control unit is illustrated in Figure 10a.

Figure 10a illustrates a circuit which acts as a driver for piezoelectric stacks 63, 64, 65 and 66. Digital-to-analog converter 94 first converts digital input at pin 98 into an analog signal at low voltage. The analog signal from digital-to-analog converter 94 is then amplified in parallel by four identical high voltage amplifiers 99, 100, 101 and 102. Such amplified outputs drives their respective piezoelectric stacks, giving rise to synchronous elongation of piezoelectric stacks 63, 64, 65 and 66. The output of high voltage amplifiers 99, 100, 101 and 102 can be any value between 0 volts and the dielectric breakdown voltage of piezoelectric stacks 63, 64, 65 and 66. Typically, this dielectric breakdown voltage can be up to 1000 volts. In addition to receiving analog input from digital-to-analog converter 94, high voltage amplifiers 99, 100, 101 and 102 are also equipped with negative inputs which are respectively driven by voltage sources V1, V2, V3 and V4. In this embodiment, voltage sources V1, V2, V3 and V4 can be selectively tuned to adjust the planarity of the aforementioned photomask or imprinting stamp 5.

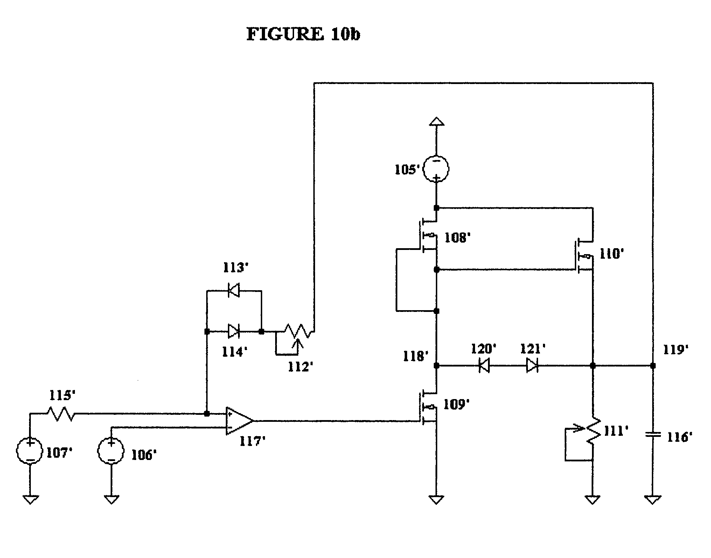

The high-voltage amplifiers 99, 100, 101 and 102 shown in Figure 10a can be four identical high-voltage, low-current drive circuits having one low-voltage input for planarity adjustment of the photomask or imprinting stamp, one low-voltage input for control of synchronous elongations of the piezoelectric stacks and one high voltage output. Preferably, it can drive high-resistance and low-capacitance piezoelectric loads. These requirements can be readily met by provision of a circuit as shown in Figure 10b, which offers a low-cost alternative to commercial high voltage amplifiers.

In Figure 10b, DC voltage source 105' is the high voltage supply rail, typically at the dielectric breakdown voltage of the piezoelectric stacks. Voltage source 106' represents the analog output of the digital-to-analog converter 94 as shown in Figure 10a. Voltage source 107' represents one of the tuning sources, V1, V2, V3 or V4 as shown in Figure 10a, which is primarily used for planarity adjustment of the photomask or imprinting stamp 5. Capacitor 106' represents the capacitive loading of one of the piezoelectric stacks, 63, 64, 65 or 66.

In Figure 10b, transistor 108' and 109' forms an inverse NMOS amplifier with the gate of transistor 109' driven by the operational amplifier 117' at a low voltage, usually between 0 and 12 volts. The output of such an inverse NMOS amplifier is formed at net 118', which is in turn mirrored into net 119' across anti-series diodes 120' and 121'. The output voltage is then fed back to the positve input of the operational amplifier 117' through resistor 112' and anti-parallel diodes 113' and 114'. The resistance of resistor 111' can be manually tuned to improve the skew rate of the output according to the capacitive loading of the piezoelectric load 116'. Typically, the skew rate can be improved by tunning resistor 111' at an expense of increased noise. Resistor 112' can be increased to increase the maximum allowable voltage at the output. Antiparallel diodes 113' and 114' improve stability by restricting the output excursion of operational amplifier 117' to one diode forward-voltage drop.

In order for the circuit in Figure 10b to drive a high-resistance and low-capacitance piezoelectric load, transistors 108', 109', 110' and 111' are preferably four identical high voltage transistors capable of operating up to 1500 volts. Typically, these transistors can be a commercially available off-the-shelf component, such as the MOSFET, 2SK1317, manufactured by Hitachi.

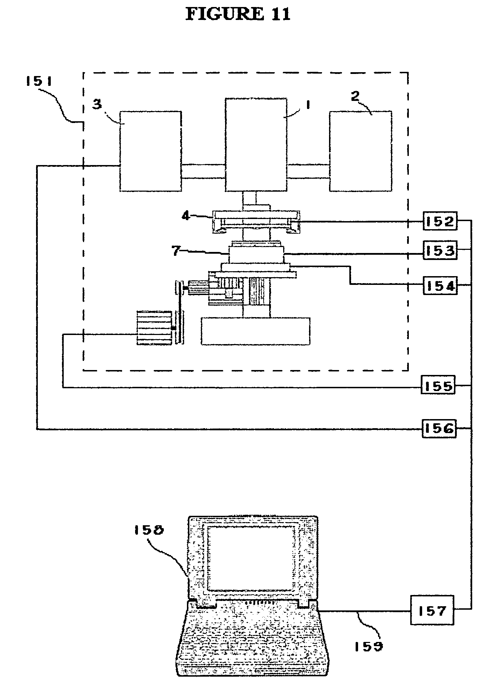

Reference is now made to Figure 11, which shows the overview of the present invention at system level. The mechanical parts of the system is enclosed in box 151. Block 152 is the aforementioned piezo-electric amplifying unit, as illustrated in Figure 1, to be used to drive the piezo-electric stacks in the mask holding device 4. Block 153 is the aforementioned temperature control unit, as illustrated in Figure 5c, which is used to drive the thermoelectric heat stack 7. Block 154 is another piezoelectric amplifying module to be used to drive the piezo-electric x-y positioning table. Block 155 is a stepper motor driver driving the stepper motor 10. Block 156 is control unit for driving the hot-air-injection unit 3, of which the details are not shown. Block 157 is a unit providing computer-driven control to blocks 152, 153, 154, 155 and 156. Control of the mechanical surface disruption step is undertaken in computer 158, which is installed with the software necessary to calculate the speed of mechanical surface disruption required to generate certain slope or profile of a sidewall. The software can be based on Equation (1) which is disclosed in UK Informal patent application GB0408169.1 and which expresses the surface displacement *uz* of the photocurable material in terms of the force and/or speed applied:

$$D\nabla^4 u_z(x,y,t) + c\frac{\partial u_z(x,y,t)}{\partial t} + m\frac{\partial^2 u_z(x,y,t)}{\partial t^2} = F(x,y,t) \qquad \text{(1a)}$$

wherein
$uz(x,y,t)$ is the vertical displacement at *(x,y)* at time *t* as a result of mechanical surface disruption; D is the flexural rigidity given as:

$$D = \frac{E(t)h^3}{12(1-v(t)^2)} \qquad \text{(1b)}$$

with *E(t), v(t)* and *h* being respectively the young's modulus at time *t,* Poisson's ratio at time *t* and the thickness of the photocurable material; *m* is the mass per unit area given as:

$$m = \rho h \qquad \text{(1c)}$$

with ρ and *h* being the density and the thickness of the photocurable material, respectively; and c is the viscous damping coefficient which can be approximated as:

$$c \approx \frac{\eta(T)}{h} \qquad \text{(1d)}$$

with η(*T*) being the temperature-dependent viscosity.

*F(x,y,t)* of Equation (1) is the forcing function, which can be separated in the spatial function *Q(x,y),* characterizing the spatial distribution of the pressure, and the time domain function *P(t):*

$$F(x,y,t) = P(t)Q(x,y) \qquad \text{(1e)}$$

Illustration of the Stamping Step

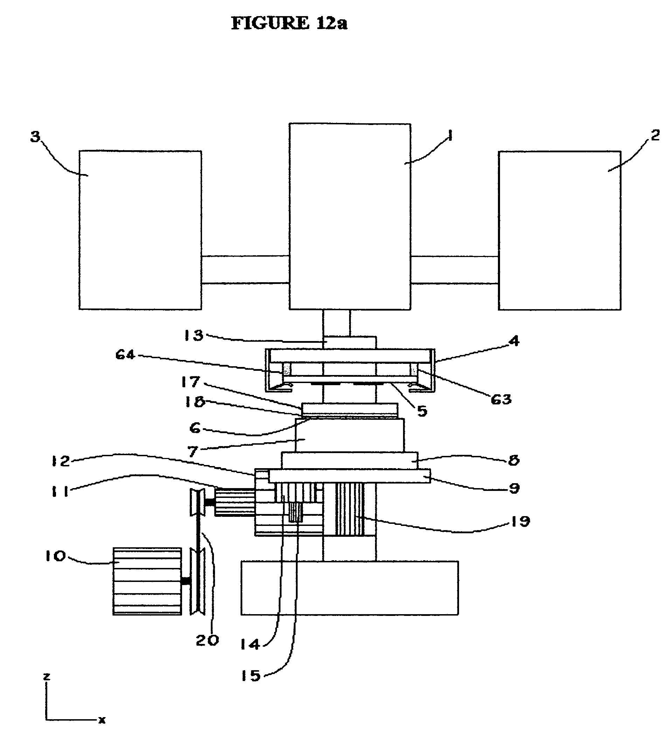

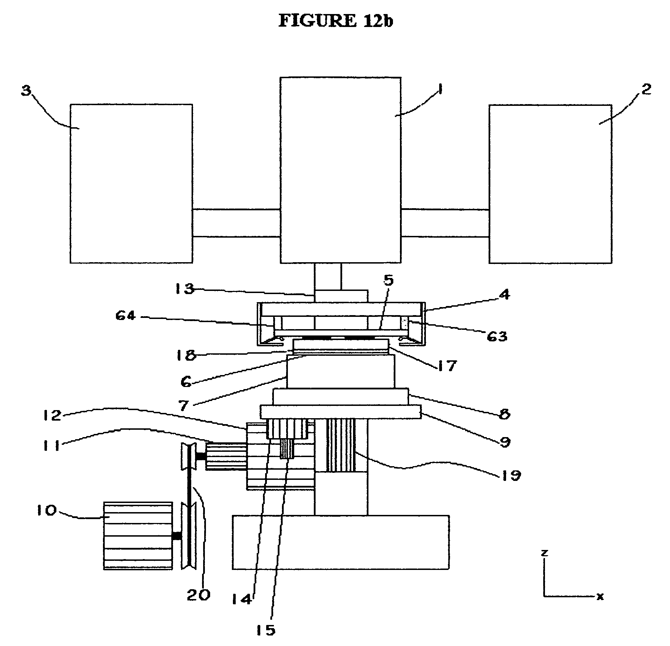

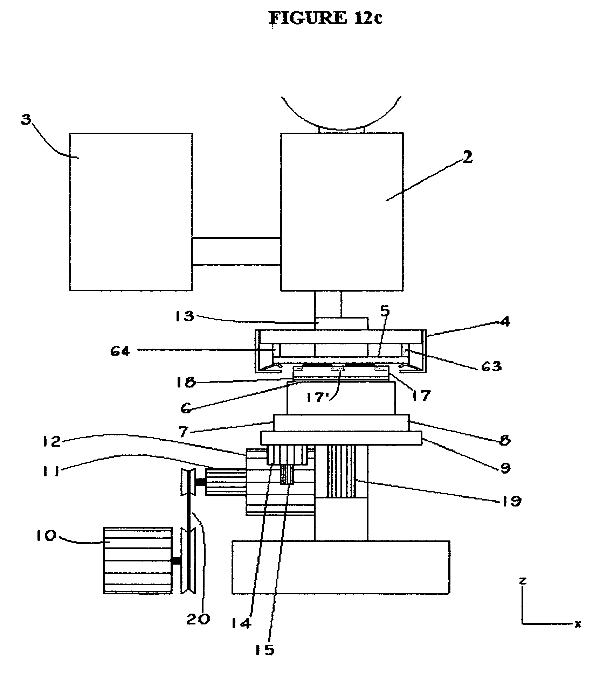

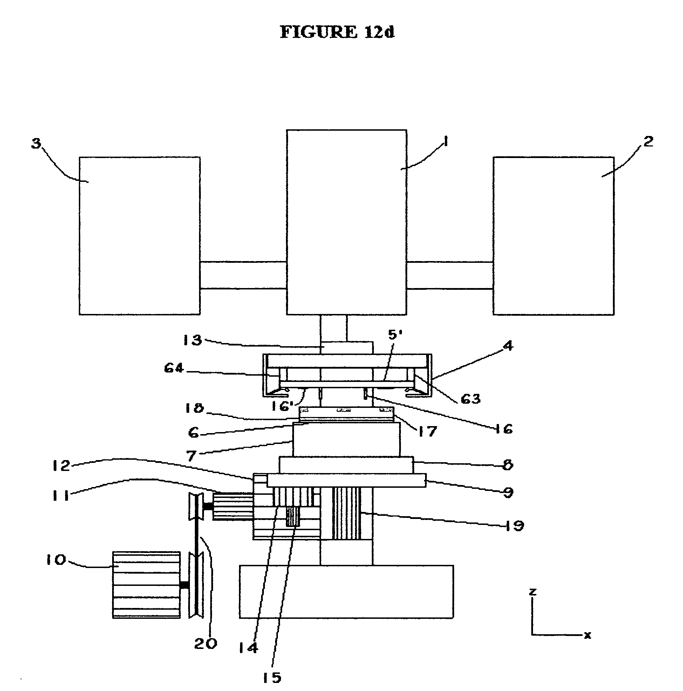

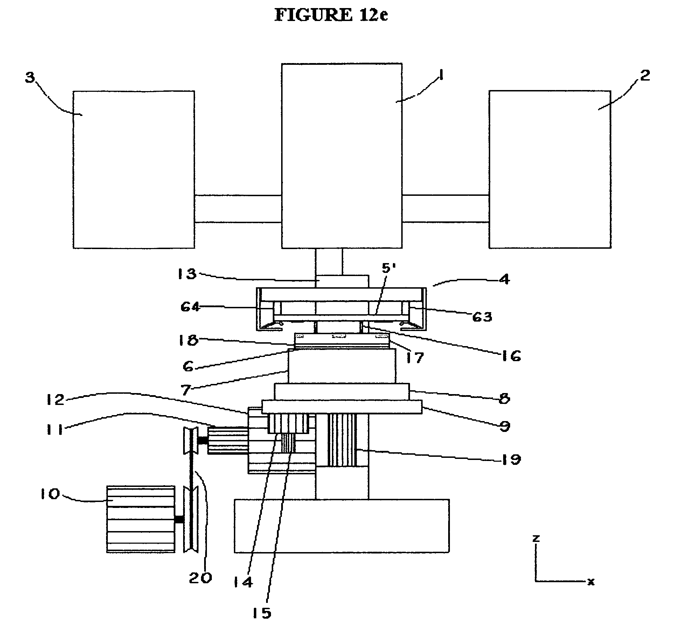

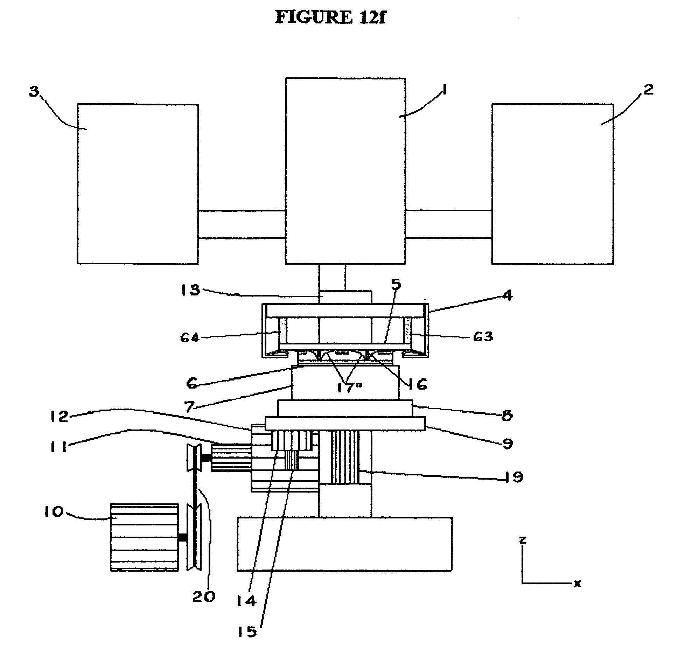

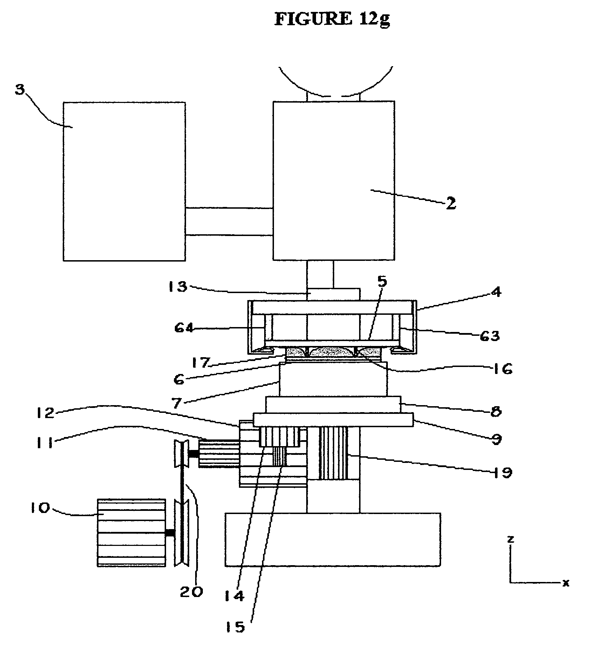

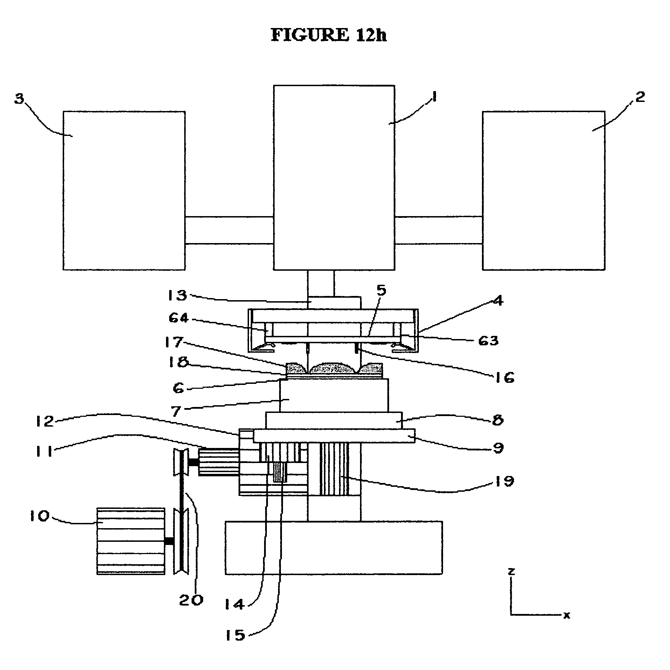

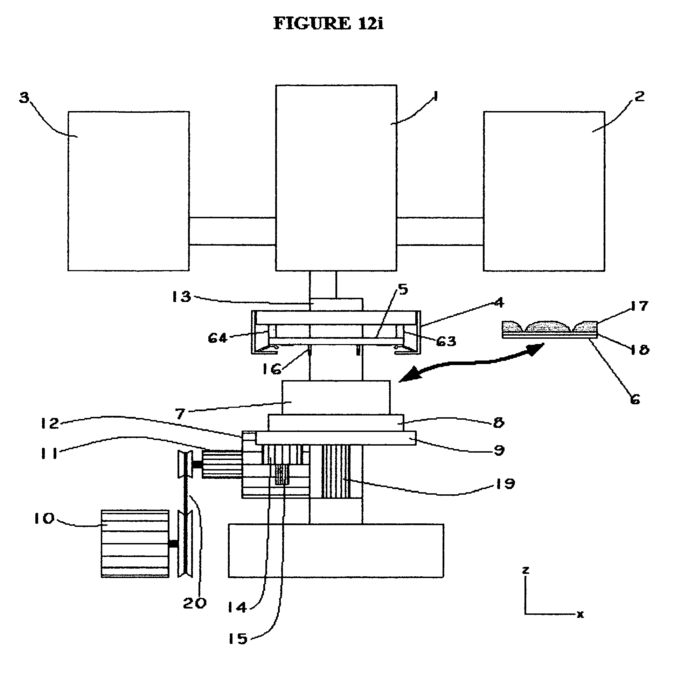

Reference is herein made to Figure 12, which illustrates the aforementioned stamping step with reference to the descriptions of the aforementioned embodiments.

During the mask-alignment step, the system is first configured to "mask alignment mode" as illustrated in Figure 12a. Herein, the photocurable material 17 is assumed to be dehydrated and adhesionless.

After the system is configured to alignment mode, the stepper motor 10 as illustrated in Figure 12b is then used to drive the wafer holding portion upwards until the photo-curable material 17 in close contact with or in proximity onto the photomask 5. Herein, the wafer holding portion comprises the detachable wafer holder 6, thermoelectric heat stage 7, piezo-electric x-y positioning table 8 and mechanical x-y positioning table 9. Herein, the photomask 5 comprises the patterns defining the upper boundaries and/or upper surfaces of the sidewalls or substructures to be formed.

After the wafer 18 is brought in close contact with the photomask 5, the aforementioned piezo-electric stacks (63, 64, 65 and 66 of Figure 7) in the mask holding device 4 are driven with appropriate voltages so to adjust the planarity of the photomask or imprinting stamp. This process continues until the imprinting stamp or photomask is in the same planarity with the surface of the photocurable material.

After the planarity of the wafer 18 is aligned with that of the photomask 5, the photo-curable material 17 on the wafer 18 can then be coarse-positioned using the mechanical x-y positioning stage 9 to obtain a coarse alignment with the photomask or imprinting stamp 5.

After the wafer 18 is roughly aligned with the photomask 5, the wafer, as shown in Figure 12b, can be fine-positioned in the x-y plane on micron scale using the piezo-electric x-y positioning table 8 thereof to obtain relatively precise alignment. With the help of the visualization unit 1, such a mask-alignment step can be undertaken with resolution in the order of 10 microns.

After the mask-alignment step, the system is now configured to "exposure mode", as illustrated in Figure 12c. The photocurable material is now partially annealed by photo-polymerization using the light source from the exposure unit. This step gives rise to the upper boundaries of the to-be-processed three dimensional microstructures or substructures.

After forming the upper boundaries of the microstructures or substructures to be fabricated, the system is configured to "alignment mode", as illustrated in Figure 12d.

After the system is configured to "alignment mode" as shown in Figure 12d, the wafer supporting portion is then moved downwards using the stepper motor 10. The thermoelectric heat stage 7 is switched to heating the photo-curable material 17 from solid to semi-solid. The original photomask 5 held in the mask holding device is now replaced with an imprinting stamp 5', which is fabricated with solid polymeric patterns 16 and conventional mask patterns 16'.

After the imprinting stamp 5' is in place, the wafer supporting portion is then moved upwardly until it forms a close contact with the polymeric patterns 16 fabricated on the imprinting stamp 5', as illustrated in Figure 12e.

After the polymeric patterns 16 is held in contact with the photocurable material 17, as illustrated in Figure 12f, the piezo-electric stacks 63, 64, 65 and 66 are now actuated synchronously with the same voltage such that the polymeric patterns 16 forms a dynamic impact with the semi-molten photocurable 17. This dynamic impact was undertaken by indentation of the polymeric patterns in a stamping speed necessary to form a required sidewall profile 17". This dynamic impact is undertaken while the photocurable material is being cooled from semi-solid to solid. The voltage waveform to be employed to drive these piezo-electric elements is programmed and controlled using a software which relates the sidewall profile 17" to the stamping speed. The end product of this step is a range of substantially convex pre-polymerized substructures having sloped or arbitrarily profiled sidewalls.

After obtaining the required substructures having sloped or arbitrarily profiled sidewalls, the system is configured to "exposure mode", as illustrated in Figure 12g. The microstructures to be formed are now photopolymerized by exposure to the light source from the exposure unit 2. This photopolymerization step can be undertaken using another photomask or the same imprinting stamp 5' if the said imprinting stamp 5' is also fabricated with required mask patterns 16'.

After the three-dimensional microstructures are fully polymerizated, the system is re-configured to "alignment mode" or "standby mode", as illustrated in Figure 12h. The wafer supporting portion is moved downwards and the detachable wafer holder 6 is unmounted.

Finally, as illustrated in Figure 12i, the polymerized microstructures in the wafer 18 is then taken away for removal of residue photocurable materials.

Illustration of Mechanical Surface Disruption Involving hot air injection

The process of mechanical surface disruption involving hot air injection is similar to the aforementioned stamping step in some respect. To start with, the process steps shown in Figure 12a-12f are first undertaken, so that the upper boundaries 5' of the to-be-processed microstructures are photo-lithographically formed.

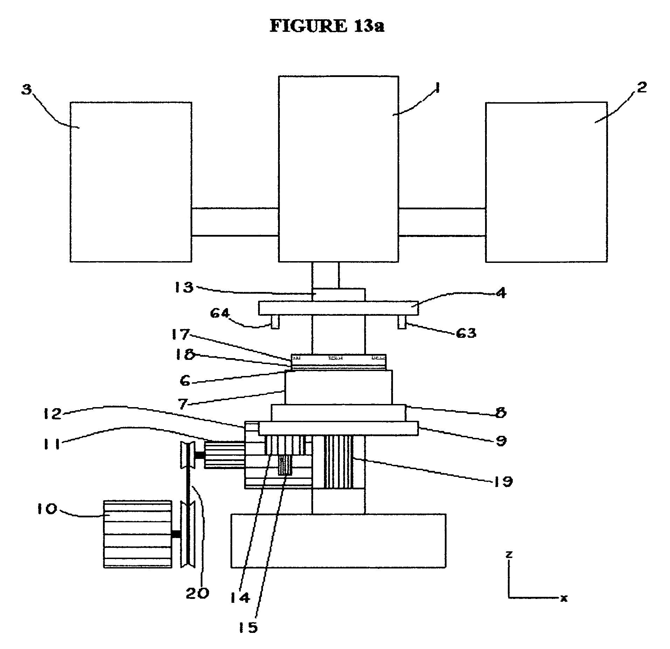

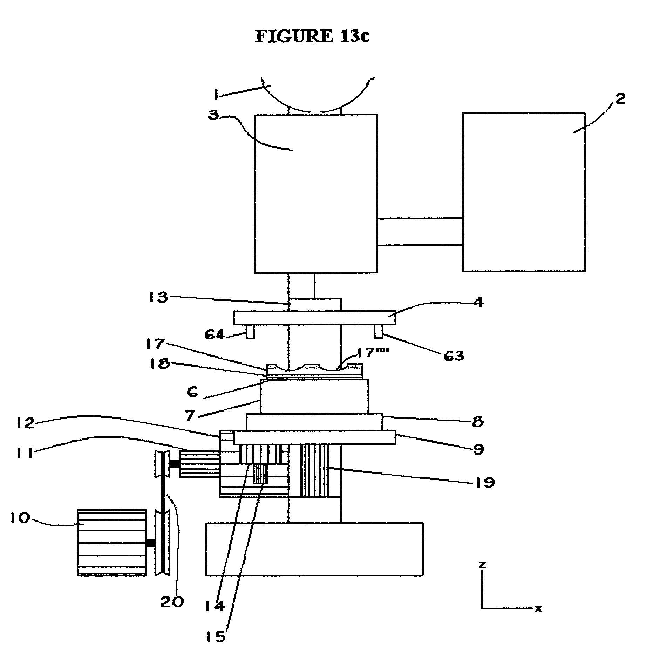

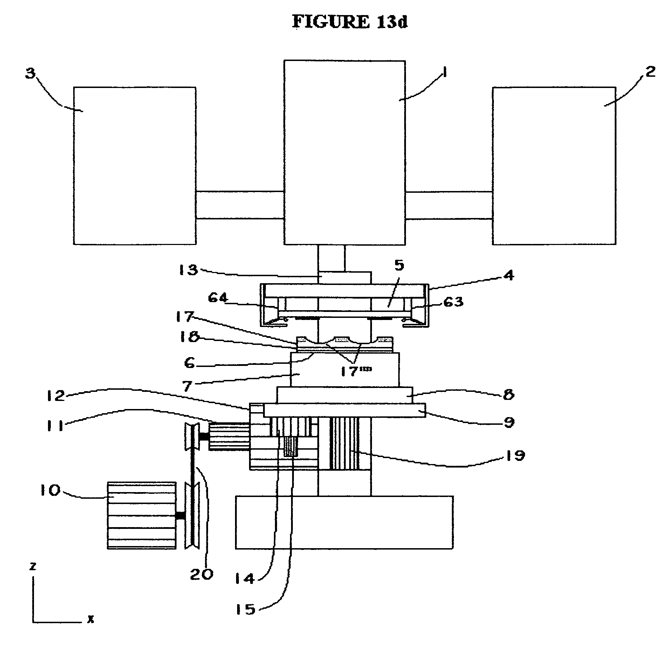

After forming the upper boundaries 5' of the to-be-processed microstructures, the original photomask 5 is unmounted from the mask holding device 4, as illustrated in Figure 13a. The photocurable material 17 is then preheated using the thermoelectric heat stage 7 from solid to semi-solid.

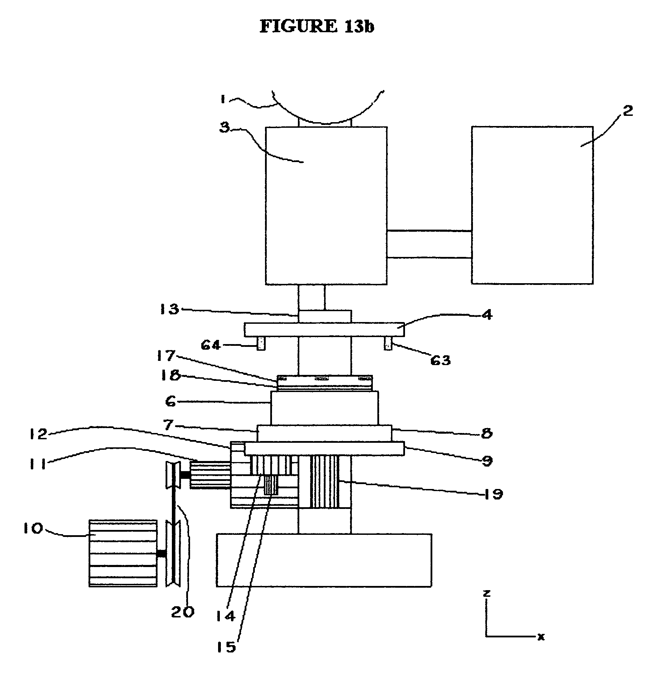

After the photocurable material 17 reaches the semi-solid state, the system is then configured to hot-air-injection mode, as illustrated in Figure 13b.

After the proposed system is configured to hot-air-injection mode, as shown in Figure 13c, the process of mechanical surface disruption involving hot-air-injection is started. Using the hot-air-injection unit 3, the photocurable material 17 is pressurized by injection with an air stream maintained at a suitable temperature and pressure. This process is undertaken when the photocurable material is being cooled from semi-solid to solid using the thermoelectric heat stage 6. The end product of this process is a range of pre-polymerized microstructures or substructures having sloped and arbitrarily concave sidewall 17"'.

After the concave sidewalls 17"' are formed, as shown in Figure 13d, the system is re-configured to "alignment mode". A photomask 5 with patterns defining the microstructures to be formed is mounted into the mask supporting device 4.

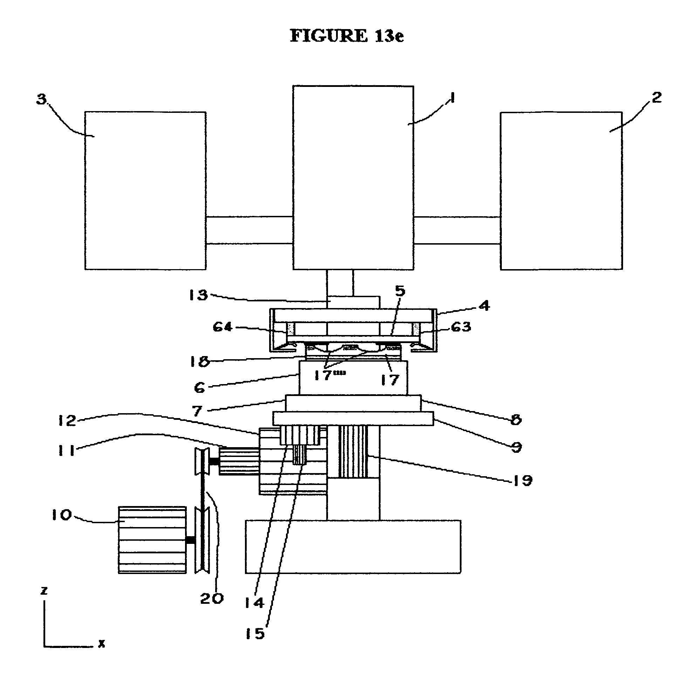

After the required photomask 5 is in place, as shown in Figure 13e, the wafer supporting portion is raised upwardly using the stepper motor 10, until the photocurable material 17 forms a close contact with the lower surface of the photomask 5. The wafer is now properly aligned with the photomask using the piezo-electric x-y positioning table 8 and mechanical x-y positioning table 9.

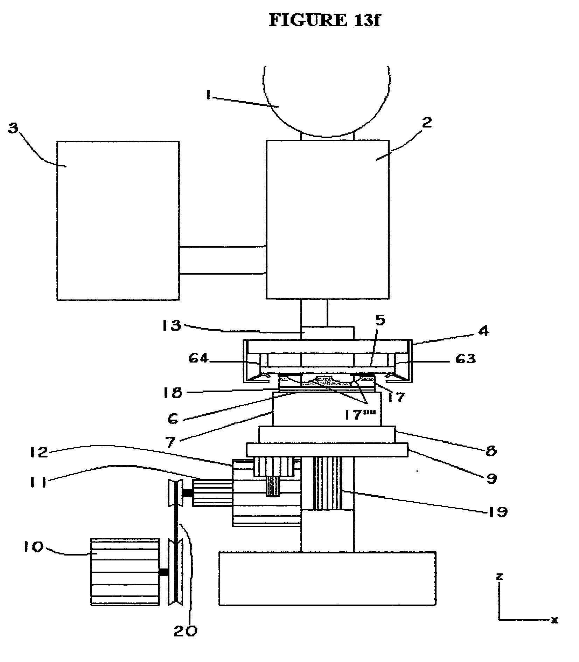

After the wafer 18 is properly aligned with the photomask 5, the system is now re-configured to "exposure mode" as illustrated in Figure 13f. The photocurable material 17 is now exposed to the light source from the exposure unit 2, thereby photo-polymerizing the three-dimensional microstructures as defined by the photomask 5.

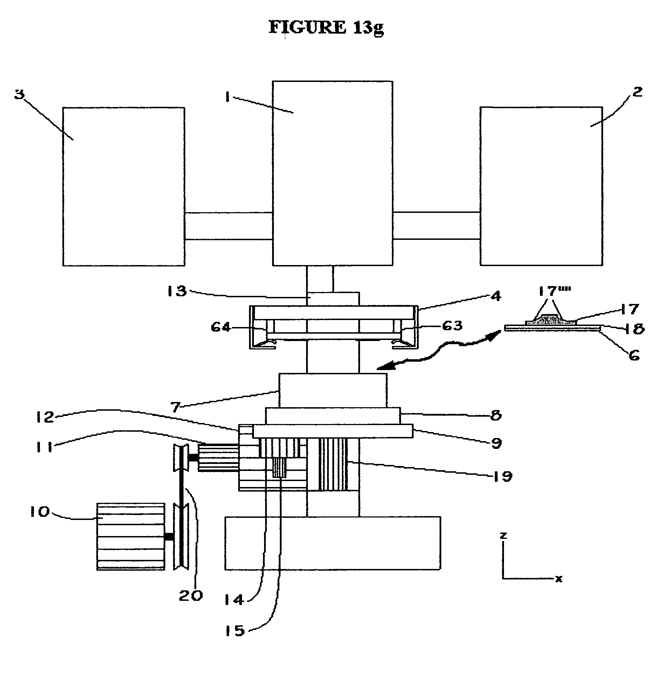

Finally, the wafer together with the polymerized microstructures therein is released from the wafer supporting portion, as shown in Figure 13g, for removal of residue photocurable material or other post-processing steps.

Although the description above contains many specificities, these should not be construed as limiting the scope of the invention but as merely providing illustrations of some of the presently preferred embodiments of this invention.

It should be understood that the foregoing drawings and accompanying descriptions are intended to be exemplary of several preferred embodiments of the invention and are not exhaustive of the possibilities of the types of systems within the intended scope of this invention. It should also be noted that modifications will readily occur to those skilled in the art within the spirit of the invention.

For example, such modifications could include, but not limited to, mounting a lever-based arrangement around each piezo-electric stack, i.e. piezo-electric stack 63, 64, 65 or 66. Such a lever-based actuating mechanism effectively amplifies the maximum available traveling depth of the stamping step at cost of less force being available for deforming the photocurable material 17.

One such arrangement is shown in figure 17, which is an adaptation of the arrangement shown in figure 7. A lever 160 is attached to the mask holding device 4 about pivot point 161 and is interposed between the stamp 5 and each piezoelectric stack 63. The free end of the lever 160 is in contact with the stamp 5 such that elongation of the stack 63 causes a force to be applied to the stamp 5 via the lever 160. A lever 160 is provided at each corner of the stamp 5 so that the elongation of each stack 63, 64, 65, 66 can be amplified in unison.

**Claims**

1.  Apparatus for the microfabrication of one or more microstructures, said apparatus including a first part and support means capable of supporting any or any combination of a mask, an imprinting stamp and/or a wafer in relation to said first part, and control means,
    **characterised in that** the support means is arranged to be selectively movable relative to said first part by way of one or more piezoelectric members under the control of the control means.

2.  Apparatus according to claim 1,
    **chracterised in that** the one or more piezoelectric members includes a plurality of members forming a piezoelectric stack.

3.  Apparatus according to claim 2,
    **characterised in that** the piezoelectric stack includes two or more ceramic members separated by one or more metallic electrodes.

4.  Apparatus according to claim 1,
    **characterised in that** the control means controls the potential difference applied across the one or more piezoelectric members so as to effect elongation of the piezoelectric members.

5.  Apparatus according to claim 1,
    **characterised in that** the piezoelectric member is disposed between the first part and the at least one supporting member.

6.  Apparatus according to claim 1,
    **characterised in that** the piezoelectric member is arranged to move the supporting member in a generally vertical orientation.

7.  Apparatus according to claim 1,
    **characterised in that** the piezoelectric member is arranged to move the supporting member in a generally horizontal orientation.

8.  Apparatus according to claim 1,
    **characterised in that** the apparatus further includes a resilient member biased against the movement of the supporting member by way of the piezoelectric member.

9. Apparatus according to claim 1,
**characterised in that** at least one piezoelectric member is arranged to selectively move the supporting member in a direction substantially parallel to the movement imparted by at least one further piezoelectric member.

10. Apparatus according to claim 1,
**characterised in that** at least one piezoelectric member is arranged to selectively move the supporting member in a direction substantially perpendiculer to the movement imparted by at least one further piezoelectric member.

11. Apparatus according to claim 1,
**characterised in that** the apparatus further includes a further movement means for coarse movement of the supporting member and the piezoelectric member provides for fine movement of the supporting member into an operative position.

12. Apparatus according to claim 1,
**characterised in that** the piezoelectric member can move the supporting member with an accuracy in the order of one micron.

13. Apparatus according to claim 1,
**characterised in that**, in the case that the supporting member supports a wafer, the wafer is removably attached to the supporting member.

14. Apparatus according to claim 14,
**characterised in that** the wafer is attached to the support member by a removable organic material.

15. Apparatus according to claim 13 or 14,
**characterised in that** the wafer is removably attached to a wafer holder, said wafer holder arranged to be removably mounted on the support member.

16. Apparatus according to claim 1,
**characterised in that** one piezoelectric member is connected in parallel with at least one other piezoelectric member to the control means.

17. Apparatus according to claim 16,
**characterised in that** a voltage amplifier is connected in series with each piezo electric member.

18. Apparatus according to claim 17,
**characterised in that** each voltage amplifier is associated with a corresponding voltage source.

19. Apparatus according to claim 1,
**characterised in that** at least one lever arrangement is provided in the force path between the support means and the one or more piezoelectric members.

20. Apparatus for the microfabrication of microstructures including a body portion and two or more operative members, said body portion including a support member for supporting any or any combination of a mask, an imprinting stamp and/or a wafer, and said operative members being movable into and out of an operative position relative to the supporting member to allow said operative members to be interchangeable for operation at different stages of a microfabrication process.

21. Apparatus according to claim 20,
**characterised in that** the operative members are any two or more of a visualization unit, an exposure unit and/or a hot air injection unit.

22. Apparatus for according to claim 20,
**characterised in that** a first operative member is movable independently of a second operative member.

23. Apparatus according to claim 20,

**characterised in that** a first operative member is movable within a plane which is different to a plane of motion of a second operative member.

24. Apparatus according to claim 23,
**characterised in that** the first operative member is movable within a plane which is perpendicular to the plane of motion of the second operative member.

25. Apparatus according to claim 20,
**characterised in that** the apparatus includes three operative members, a first operative member being movable into and out of an operative position in one plane and a second and a third operative member being movable into and out of an operative position in a second plane.

26. Apparatus according to claim 20,
**characterised in that** at least one operative member is pivotally attached to the body portion.

27. Apparatus according to claim 26,
**characterised in that** the at least one operative member is pivotally attached to the body portion by way of an arm extending between the operative member and the body portion.


**Amended claims in accordance with Rule 86(2) EPC.**

**1.** An apparatus for fabricating three-dimenisonal microstructures with arbitrarily profiled sidewalls by mechanical surface deformation means, comprising:

a stamp-holding means for effecting planarity adjustment of a photomask/imprinting stamp and surface deformation by stamping;
a wafer-holding means for two-dimensional positioning, heating and cooling of a photocurable material;
a means for visual examination of micro-features to be fabricated;
a means for photopolymerization of a photocurable materials;
a means for injection of air at an elevated temperature; and
an electronic system for control of the pressure and temperature of the injected air from the hot-air-injection unit, planarity adjustment of the imprinting stamp, temperature variation of the wafer containing a photocurable material and/or stamping of a photocurable material on a control manner.

**2.** apparatus according to claim 1, **characterized in that**
the stamp-holding means is a rectangular frame having four piezo-electric stacks and four leaf springs mounted in the four corners of the frame.

**3.** apparatus according to claims 2, **characterized in that**
the rectangular frame is attached to a slider which allows a photo-mask/imprinting-stamp to be manually moved with respect to the wafer-holding means in the substantially vertical direction.

**4.** apparatus according to claim 3, **characterized in that**
the stamp-holding means allows a photo-mask or an imprinting stamp to be mounted and detached.

**5.** apparatus according to claims 3-4, **characterized in that**
a photo-mask/imprincing-stamp can be mounted on the stamp-holding means by sandwiching each corner of said imprinting-stamp/photo-mask between one of said piezo-electric stacks and one of said leaf springs.

**6.** apparatus according to claims 3-4, **characterized in that**
a photo-mask/imprinting-stamp can be mounted on the stamp-holding means by supporting a corner of the photo-mask/imprinting-stamp on a lever mechanism sandwiched between a piezo-electric stack column and a leaf spring.

**7.** apparatus according to claim 1, **characterized in that**
the wafer-holding means comprises, at least, an xy-positioning table for two-dimensional positioning of the photocurable material, a water-block for removal of surplus heat accumulated in the wafer-holding means, a thermoelectric module containing a plurality of peltier elements for cooling the photocurable material, a resistive heating module containing a plurality of resistive heating elements for heating the photocurable material, and a removable plate for holding a wafer of photocurable material.

**8.** apparatus according to claim 7, **characterized in that**
the water-block is sandwiched between the xy-positioning table and the thermoelectric module, with the xy-positioning table mounted on the bottom.

**9.** apparatus according to claim 7, **characterized in that**
the thermoelectric module is sandwiched between the water block and the resistive heating module, with the hot side of the peltier elements facing the water block.

**10.** apparatus according to claim 7, **characterized in that**
mounted on the top of the resistive heating module is the removable plate which allows a to-be-processed wafer to be temporarily adhered using an appropriate adhesive material.

**11.** apparatus according to claim 7, **characterized in that**
the water-block allows water to flow through continuously for removal of surplus heat accumulated during the process of wafer temperature control.

**12.** apparatus according to claim 1, **characterized in that**
an electronic system is a circuit further comprising, at least, a wafer-temperature control unit for control of the heating module and the thermoelectric module according to claim 14, a stamping-control unit for control of the piezo-electric stacks according to claims 2-8, a hot-air-injection control unit for control of the hot-air-injection means according to claim 1, and a further unit for master control of the wafer-temperature unit, the stamping-control unit and the hot-air-injection control unit.

**13.** apparatus according to claim 12, **characterized in that**
the wafer-temperature control unit further comprises, at least, an amplifier for powering the heating module, an amplifier for powering the thermoelectric module, a high-current transformerless power source, and a temperature sensing means for measuring wafer temperature and for provision of feedback control according to the wafer temperature.

**14.** apparatus according to claim 12, **characterized in that**
the amplifiers within the wafer-temperature control unit are connected to the temperature sensing means which automatically switches between heating and cooling in accordance to the measured temperature of the photocurable material.

**15.** apparatus according to claim 12, **characterized in that**
the two amplifiers are driven by a high-current transformer-less power source for effecting substantially low-noise heating or cooling of the wafer.

**16.** apparatus according to claim 13, **characterized in that**
the temperature sensing means automatically switches off the resistive module and switches on the amplifier for the thermoelectric module when the measured wafer temperature is higher than the desired temperature.

**17.** apparatus according to claim 13, **characterized in that**
the temperature sensing means automatically switches off the thermoelectric module and switches on the amplifier for powering the resistive heating module when the measured wafer temperature is lower than the desired temperature.

**18.** apparatus according to claim 13, **characterized in that**
wafer-cooling can be accelerated by increasing the amplification factor of the amplifier for powering the thermoelectric module.

**19.** apparatus according to claim 13, **characterized in that**
wafer-heating can be accelerated by increasing the amplification factor of the amplifier for powering the resistive heating module.

**20.** apparatus according to claim 13, **characterized in that**
the stamping-control comprises at least a digital-to-analog module and four piezo-electric amplifiers for elongating the four piezo-electric stacks according to claims 2-8.

**21.** apparatus according to claim 12, **characterized in that**
each of the four piezo-electric amplifiers has one input which can be selectively tuned for pre-setting and/or fine-adjusdng the planarity of the imprinting stamp/photo-mask according to claims 2-8.

**22.** apparatus according to claim 12, **characterized in that**
each of the piezo-electric amplifiers has another input connected in parallel to the digital-to-analog module which synchronously drives the piezo-electric stacks with an appropriate voltage waveform to effect a surface deformation step by stamping according to claim 1.

**23.** apparatus according to claim 12, **characterized in that**
the hot-air-injection control unit controls the pressure and temperature of the air injected by the hot-air-injection means for effecting the surface deformation step by hot-air-injection.

**24.** apparatus according to claim 12, **characterized in that**
the stamping-control unit, the hot-air-injection unit and the temperature-control unit are separately interfaced to the further unit for master-control which comprises a means for real-time control of the pressure and temperature of the injected air from the hot-air-injection unit according to claim 23, a means for real-time control of the wafer temperature according to claims 12-21 and a means for real-time control of the speed and the planarity of the imprinting stamp mounted according to either claims 5 or 6.

**25.** apparatus according to claim 15, **characterized in that**
the unit for master control of the wafer-temperature unit, the stamping-control unit and the hot-air-injection control unit further comprises a means for changing the sidewall profiles by changing the rate of temperature change in the photocurable material and the speed at which the mechanical surface deformation is undertaken.

**26.** a method of formation of microstructures with arbitrarily profiled sidewalls according to claim 1, comprising the steps of
dehydrating a photocurable material using the hot-air-injection unit,
partially polymerizing selected areas using the photopolymerization unit to form upper boundaries adjacent to or enclosing sidewalls to be formed,
raising the temperature of the wafer to maintain the photocurable material in a semi-molten state using the heating module within the wafer-holding means,
using the unit for master control according to claim 25 to mechanically deform areas by stamping or by hot-air-injection in vicinity of or enclosed by the upper boundaries while cooling the photocurable material,
selectively photo-polymerizing areas including mechanically deformed structures, and
repeating the above-mentioned steps for formation of other sidewalls, structures or substructures, until the end microstructures are completely formed.

## Figure 1a

# FIGURE 1b

# FIGURE 1c

## FIGURE 2

# FIGURE 3

**FIGURE 4**

## FIGURE 5a

## FIGURE 5b

**FIGURE 6a**

FIGURE 6b

EP 1 659 450 A1

## FIGURE 6c

Va

V[127,129]

V[127,128]

V[128,129]

VDD2

28

## FIGURE 7a

## FIGURE 7b

# FIGURE 7c

FIGURE 8a

FIGURE 8b

## FIGURE 9a

## FIGURE 9b

## FIGURE 9c

## FIGURE 9d

## FIGURE 10a

FIGURE 10b

# FIGURE 11

# FIGURE 12a

**FIGURE 12b**

## FIGURE 12c

**FIGURE 12d**

**FIGURE 12e**

# FIGURE 12f

## FIGURE 12g

## FIGURE 12h

**FIGURE 12i**

## FIGURE 13a

**FIGURE 13b**

## FIGURE 13c

**FIGURE 13d**

## FIGURE 13e

**FIGURE 13f**

## FIGURE 13g

# FIGURE 14

# FIGURE 15

```
        ┌─────────┐
        │    a    │
        └─────────┘
             │
             ▼
        ┌─────────┐
        │    b    │
        └─────────┘
             │
             ▼
        ┌─────────┐
        │    c    │
        └─────────┘
             │
             ▼
        ┌─────────┐
        │    d    │
        └─────────┘
             │
             ▼
        ┌─────────┐
        │    e    │                no
        └─────────┘
             │
             ▼
        ┌─────────┐
        │    f    │
        └─────────┘
             │
             ▼
        ┌─────────┐
        │    g    │
        └─────────┘
             │
             ▼
           ◇ finish ? ◇
```

**European Patent Office**

**EUROPEAN SEARCH REPORT**

Application Number

EP 05 00 0788

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 782 236 A (CHITAYAT ET AL) 1 November 1988 (1988-11-01) * abstract * * figures 1-6 * * column 1, line 6 - line 9 * * column 1, line 38 - line 42 * * column 3, line 41 - line 49 * * column 4, line 43 - column 5, line 59 * | 1-4,6,8, 9,11-19 | G03F7/20 G03F7/00 |
| A | | 20 | |
| X | US 4 575 942 A (MORIYAMA ET AL) 18 March 1986 (1986-03-18) * abstract * * figure 1 * * column 1, line 7 - line 12 * * column 1, line 55 - column 2, line 21 * | 1-5,7, 9-13, 15-19 | |
| A | | 20 | |
| X | US 4 040 736 A (JOHANNSMEIER ET AL) 9 August 1977 (1977-08-09) * abstract * * figures 1,3,6 * * column 1, line 12 - line 22 * * column 5, line 14 - line 22 * * column 12, line 19 - line 36 * * column 13, line 61 - column 14, line 17 * | 20,21, 23-27 | TECHNICAL FIELDS SEARCHED (Int.Cl.7) H01L G03F |
| A | | 1 | |
| X | EP 0 322 205 A (TEXAS INSTRUMENTS INCORPORATED) 28 June 1989 (1989-06-28) * abstract * * figures 7,8 * * column 2, line 13 - line 19 * * column 7, line 44 - column 8, line 3 * | 20,22, 26,27 | |
| A | | 1 | |

-/--

The present search report has been drawn up for all claims

| Place of search | Date of completion of the search | Examiner |
|---|---|---|
| The Hague | 15 September 2005 | Andersen, O |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 05 00 0788

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 6 712 132 B1 (GREEN REVVIE A) 30 March 2004 (2004-03-30) * abstract * * figures 1-6 * * column 1, line 8 - line 11 * * column 4, line 4 - line 8 * ----- | 1,20 | |

TECHNICAL FIELDS SEARCHED (Int.Cl.7)

The present search report has been drawn up for all claims

| Place of search | Date of completion of the search | Examiner |
|---|---|---|
| The Hague | 15 September 2005 | Andersen, O |

**ANNEX TO THE EUROPEAN SEARCH REPORT
ON EUROPEAN PATENT APPLICATION NO.**                          EP 05 00 0788

This annex lists the patent family members relating to the patent documents cited in the above-mentioned European search report.
The members are as contained in the European Patent Office EDP file on
The European Patent Office is in no way liable for these particulars which are merely given for the purpose of information.

15-09-2005

| Patent document cited in search report | | Publication date | Patent family member(s) | | Publication date |
|---|---|---|---|---|---|
| US 4782236 | A | 01-11-1988 | NONE | | |
| US 4575942 | A | 18-03-1986 | NONE | | |
| US 4040736 | A | 09-08-1977 | NONE | | |
| EP 0322205 | A | 28-06-1989 | JP | 2002605 A | 08-01-1990 |
| US 6712132 | B1 | 30-03-2004 | NONE | | |

EPO FORM P0459

For more details about this annex : see Official Journal of the European Patent Office, No. 12/82